(19) Europäisches Patentamt / European Patent Office / Office européen des brevets

(11) **EP 4 201 902 A1**

(12) **EUROPEAN PATENT APPLICATION**
published in accordance with Art. 153(4) EPC

(43) Date of publication:
**28.06.2023 Bulletin 2023/26**

(21) Application number: **21858219.5**

(22) Date of filing: **10.08.2021**

(51) International Patent Classification (IPC):
*C03C 10/04* (2006.01)     *C03B 32/02* (2006.01)
*C03C 10/02* (2006.01)     *C03C 21/00* (2006.01)

(52) Cooperative Patent Classification (CPC):
**C03B 32/02; C03C 10/00; C03C 21/00**

(86) International application number:
**PCT/JP2021/029569**

(87) International publication number:
**WO 2022/039072 (24.02.2022 Gazette 2022/08)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **21.08.2020   JP 2020140347
28.05.2021   JP 2021090475**

(71) Applicant: AGC INC.
**Chiyoda-ku,
Tokyo 1008405 (JP)**

(72) Inventors:
• **FURUTA, Hitomi**
  **Tokyo 100-8405 (JP)**
• **LI, Qing**
  **Tokyo 100-8405 (JP)**
• **SAWAMURA, Shigeki**
  **Tokyo 100-8405 (JP)**
• **AKIBA, Shusaku**
  **Tokyo 100-8405 (JP)**
• **INABA, Seiji**
  **Tokyo 100-8405 (JP)**

(74) Representative: **Müller-Boré & Partner
Patentanwälte PartG mbB
Friedenheimer Brücke 21
80639 München (DE)**

(54) **CHEMICALLY STRENGTHENED GLASS AND CRYSTALLIZED GLASS, AND MANUFACTURING METHODS THEREFOR**

(57)    The present invention relates to a chemically strengthened glass having a haze value in terms of a thickness of 0.7 mm of 0.5% or less, having a surface compressive stress value of 400 MPa or more, having a depth of a compressive stress layer of 70 $\mu$m or more, having an ST limit of 18000 MPa·$\mu$m to 30000 MPa·$\mu$m, and being a glass ceramic including at least one of a $Li_3PO_4$ crystal and a $Li_4SiO_4$ crystal, or including a solid solution crystal of $Li_3PO_4$ or $Li_4SiO_4$ or a solid solution of both $Li_3PO_4$ and $Li_4SiO_4$.

FIG. 1

EP 4 201 902 A1

**Description**

TECHNICAL FIELD

The present invention relates to a glass ceramic, a chemically strengthened glass, and a method for producing the same.

BACKGROUND ART

A chemically strengthened glass is used as a cover glass or the like of a mobile terminal. The chemically strengthened glass is a glass in which a compressive stress layer is formed on a glass surface by, for example, bringing a glass into contact with a molten salt containing alkali metal ions to cause ion exchange between alkali metal ions in the glass and alkali metal ions in the molten salt.

Glass ceramics are obtained by precipitating crystals in glass, and are harder and less likely to be damaged than an amorphous glass that does not contain crystals. In addition, since the glass ceramics that can be chemically strengthened have a larger CT limit as compared with the amorphous glass, it is possible to achieve high strength while preventing fracturing. However, the glass ceramics in the related art often have insufficient transparency compared to the amorphous glass.

The chemically strengthened glass has a higher strength as a compressive stress formed on the surface is large, but a tensile stress (CT) canceling the formed compressive stress is generated inside the chemically strengthened glass. If CT is too large, the chemically strengthened glass is severely fractured when the chemically strengthened glass is cracked. A limit tensile stress value at which severe fracturing can be prevented is called CT limit.

Patent Literature 1 describes an example in which glass ceramics are subjected to ion exchange treatment and are chemically strengthened.

CITATION LIST

PATENT LITERATURE

Patent Literature 1: WO 2019/022035

SUMMARY OF INVENTION

TECHNICAL PROBLEM

The glass ceramics described in Patent Literature 1 may be insufficient in transparency although the glass ceramics are excellent in transparency and chemical strengthening properties. In addition, since a heat treatment temperature required for melting and crystallization of glass raw materials is high, there was a concern in terms of productivity.

The present invention provides an amorphous glass that is excellent in transparency and strength and has a large thermal expansion coefficient, glass ceramics that are excellent in transparency and chemical strengthening properties, have a large thermal expansion coefficient, and can be produced at a relatively low temperature, and a chemically strengthened glass that is excellent in transparency and strength and has a large thermal expansion coefficient.

SOLUTION TO PROBLEM

The present invention relates to a chemically strengthened glass having a haze value in terms of a thickness of 0.7 mm of 0.5% or less,

    having a surface compressive stress value of 400 MPa or more,
    having a depth of a compressive stress layer of 70 $\mu$m or more,
    having an ST limit determined by the following test method of 18000 MPa·$\mu$m to 30000 MPa·$\mu$m, and
    being a glass ceramic including at least one of a $Li_3PO_4$ crystal and a $Li_4SiO_4$ crystal, or including a solid solution crystal of $Li_3PO_4$ or $Li_4SiO_4$ or a solid solution of both $Li_3PO_4$ and $Li_4SiO_4$,

TEST METHOD:

as a test glass sheet, a glass sheet having a 15 mm square and a thickness of 0.7 mm and having a mirror-finished surface is subjected to a chemical strengthening treatment under various conditions to prepare a plurality of test glass sheets having different ST values which are tensile stress integral values;

using a Vickers tester, a diamond indenter with a tip angle of 90° is driven into a central portion of the test glass sheet to fracture the glass sheet, and the number of broken pieces is defined as a fragmentation number, in a case where the glass sheet is not cracked after a test is started with a driving load of the diamond indenter of 1 kgf, the driving load is increased by 1 kgf each time, the test is repeated until the glass sheet is cracked, and the fragmentation number when the glass sheet is cracked for the first time is counted; and

the fragmentation number is plotted with respect to an ST value of the test glass sheet, and an ST value at which the fragmentation number is 10 is read and is regarded as the ST limit.

The present invention relates to a glass ceramic including at least one of a $Li_3PO_4$ crystal and a $Li_4SiO_4$ crystal, or including a solid solution crystal of $Li_3PO_4$ or $Li_4SiO_4$ or solid solution of both $Li_3PO_4$ and $Li_4SiO_4$,

having a haze value in terms of a thickness of 0.7 mm of 0.5% or less, and
having a tensile stress integral value ST limit of 18000 MPa·$\mu$m or more.

The present invention relates to a glass ceramic including, in terms of mol% based on oxides:

40% to 70% of $SiO_2$;
10% to 35% of $Li_2O$;
1% to 15% of $Al_2O_3$;
0.5% to 5% of $P_2O_5$;
0.5% to 5% of $ZrO_2$;
0% to 10% of $B_2O_3$;
0% to 3% of $Na_2O$;
0% to 1% of $K_2O$; and
0% to 4% of $SnO_2$,
having a total content of $SiO_2$, $Al_2O_3$, PzOs, and $B_2O_3$ of 60% to 80%, and
having a ratio of a total content of $Li_2O$, $Na_2O$ and $K_2O$ to the total content of $SiO_2$, $Al_2O_3$, PzOs and $B_2O_3$ of 0.20 to 0.60 and including $Li_3PO_4$ or $Li_4SiO_4$ as a main crystal.

The present invention relates to a method for producing a glass ceramic, the method including performing a heat treatment to hold a glass at a temperature of 450°C or higher and 800°C or lower,
the glass including, in terms of mol% based on oxides:

40% to 70% of $SiO_2$;
10% to 35% of $Li_2O$;
1% to 15% of $Al_2O_3$;
0.5% to 5% of $P_2O_5$;
0.5% to 5% of $ZrO_2$;
0% to 10% of $B_2O_3$;
0% to 3% of $Na_2O$;
0% to 1% of $K_2O$; and
0% to 4% of $SnO_2$,
having a total content of $SiO_2$, $Al_2O_3$, PzOs, and $B_2O_3$ of 60% to 80%, and
having a ratio of a total content of $Li_2O$, $Na_2O$ and $K_2O$ to the total content of $SiO_2$, $Al_2O_3$, PzOs and $B_2O_3$ of 0.20 to 0.60.

The present invention also provides a semiconductor support substrate including the amorphous glass, the glass ceramic, or the chemically strengthened glass.

ADVANTAGEOUS EFFECTS OF INVENTION

According to the present invention, an amorphous glass that is excellent in transparency and strength and further has a large thermal expansion coefficient can be obtained. The present invention also provides a glass ceramic that is excellent in transparency and chemical strengthening properties and have a large thermal expansion coefficient. The present invention also provides a chemically strengthened glass that is excellent in transparency and strength and has a large thermal expansion coefficient.

BRIEF DESCRIPTION OF DRAWINGS

FIG. 1 shows a result of X-ray diffraction of glass ceramic.
FIG. 2 shows a stress profile of a chemically strengthened glass.
FIG. 3 shows a cross section FE-SEM image of glass ceramic. In the figure, a white arrow indicates an example of a precipitated crystal.
FIG. 4 is an explanatory diagram of a sample used for measurement of a fracture toughness value K1c by a DCDC method.
FIG. 5 shows a K1-v curve showing a relationship between a stress intensity factor K1 (unit: MPa·m$^{1/2}$) and a crack growth rate v (unit: m/s), which is used for measurement of a fracture toughness value K1c by a DCDC method.
FIG. 6A and FIG. 6B illustrate a support glass according to an aspect of the present invention which is bonded to a semiconductor substrate, FIG. 6A is a cross-sectional view before bonding, and FIG. 6B is a cross-sectional view after bonding.
FIG. 7 is a cross-sectional view of a laminated substrate according to an aspect of the present invention.

DESCRIPTION OF EMBODIMENTS

In the present specification, unless otherwise specified, the expression "to" indicating a numerical range is used to include numerical values described therebefore and thereafter as a lower limit value and an upper limit value.

In the present specification, the term "amorphous glass" refers to a glass in which a diffraction peak showing crystals is not observed by a powder X-ray diffraction method to be described later. The term "glass ceramic" refers to a glass obtained by heat-treating an "amorphous glass" to precipitate crystals, and contains crystals. In the present specification, an "amorphous glass" and "glass ceramic" are collectively referred to as a "glass". In addition, an amorphous glass to be glass ceramic by a heat treatment may be referred to as a "base glass of glass ceramic".

In the present specification, in the powder X-ray diffraction measurement, a range of $2\theta$ of $10°$ to $80°$ is measured using CuKa ray, and when a diffraction peak appears, precipitated crystals are identified by the Hanawalt method. In addition, a main crystal is a crystal identified from a peak group including a peak having the highest integral intensity among the crystals identified by the method. For example, SmartLab manufactured by Rigaku Corporation can be used as a measurement device.

In the following, the term "chemically strengthened glass" refers to a glass after being subjected to a chemical strengthening treatment, and the term "glass for chemical strengthening" refers to a glass before being subjected to a chemical strengthening treatment.

In the present specification, the glass composition is expressed in terms of mol% based on oxides unless otherwise specified, and mol% is simply expressed as "%".

In addition, in the present specification, the phrase "not substantially contained" means that an amount of a component is equal to or lower than a level of an impurity contained in a raw material or the like, that is, the component is not intentionally added. Specifically, the amount is, for example, less than 0.1%.

In the present specification, the term "stress profile" represents a compressive stress value with a depth from a glass surface as a variable. In the stress profile, a tensile stress is expressed as a negative compressive stress.

The "compressive stress value (CS)" can be measured by thinning a cross section of a glass and analyzing the thinned sample by a birefringence imaging system. A birefringence stress meter of the birefringence imaging system is a device that measures a magnitude of retardation caused by a stress using a polarizing microscope and a liquid crystal compensator, and is, for example, a birefringence imaging system Abrio-IM manufactured by CRi.

In addition, the compressive stress value can also be measured using scattered-light photoelasticity. In the method, light is incident from a surface of the glass, and polarization of the scattered light thereof can be analyzed to measure the CS. Examples of a stress measuring device using the scattered-light photoelasticity include a scattered light photoelastic stress meter SLP-2000 manufactured by Orihara Industrial Co., Ltd.

In the present specification, the term "depth of a compressive stress layer (DOL)" is a depth at which a compressive stress value is zero. Hereinafter, a surface compressive stress value may be referred to as $CS_0$, and a compressive stress value at a depth of 50 $\mu$m may be referred to as $CS_{50}$. The term "internal tensile stress (CT)" refers to a tensile stress value at a depth of 1/2 of a sheet thickness t.

The term "tensile stress integral value (ST value)" refers to an area integral of a tensile stress (negative compressive stress) with respect to a sample depth from the DOL to the depth of 1/2 of the sheet thickness t. In the chemically strengthened glass, when the ST value in the glass is equal to or larger than a certain threshold value, the fragmentation number rapidly increases when the glass is fractured. The threshold value is referred to as an "ST limit".

In the present specification, the "ST limit" is measured by the following method.

(Measurement Method of ST Limit)

As a test glass sheet, a glass sheet having a 15 mm square and a thickness of 0.7 mm and having a mirror-finished surface is subjected to a chemical strengthening treatment under various conditions to prepare a plurality of test glass sheets having different ST values.

Using a Vickers tester, a diamond indenter with a tip angle of 90° is driven into a central portion of the test glass sheet to fracture the glass sheet, and the number of broken pieces is defined as the fragmentation number. In a case where the glass sheet is not cracked after a test is started with a driving load of the diamond indenter of 1 kgf, the driving load is increased by 1 kgf each time, the test is repeated until the glass sheet is cracked, and the number of broken pieces when the glass sheet is cracked for the first time is counted.

The fragmentation number is plotted with respect to an ST value of the test glass sheet, and an ST value at which the fragmentation number is 10 is read and is regarded as the ST limit.

In the present specification, the term "light transmittance" refers to an average transmittance for light having a wavelength of 380 nm to 780 nm. The "haze value" is measured using a halogen lamp C light source in accordance with JIS K7136:2000.

In the present specification, the "fracture toughness value Kc" is a value obtained by the IF method defined in JIS R1607:2015.

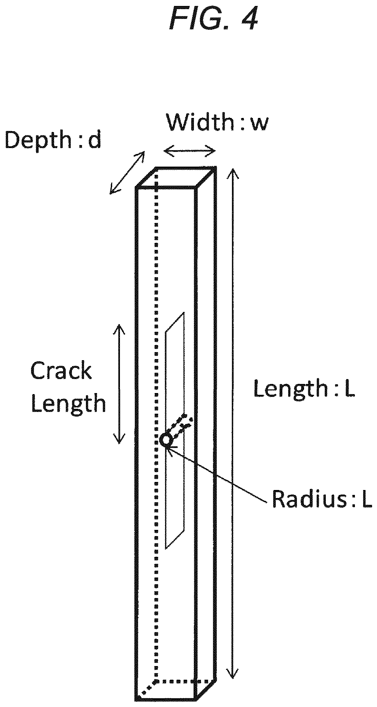

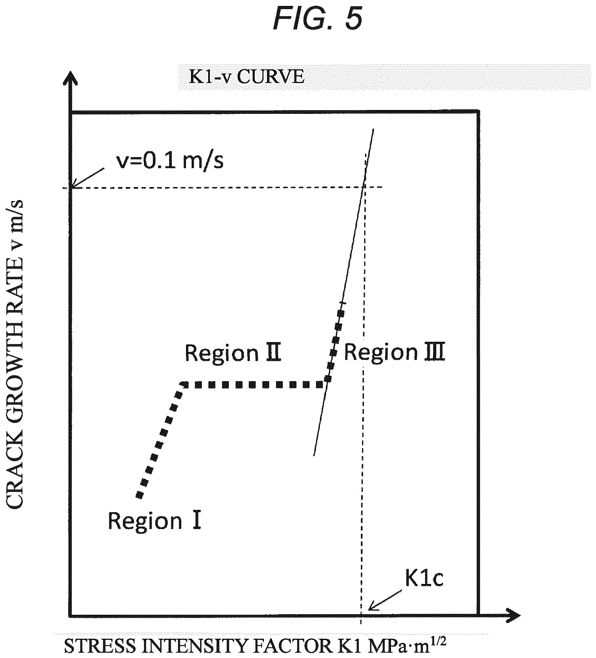

In the present specification, the "fracture toughness value K1c" is measured by the DCDC method [reference document: M.Y. He, M.R. Turner and A.G. Evans, Acta Metall. Mater. 43 (1995) 3453.]. Specifically, by using a sample having a shape shown in FIG. 4 and a SHIMADZU autograph AGS-X5KN, a K1-v curve showing a relationship between a stress intensity factor K1 (unit: $MPa \cdot m^{1/2}$) and a crack growth rate v (unit: m/s) as shown in FIG. 5 is measured, the obtained data of Region III is regressed by a linear expression and extrapolated, and the stress intensity factor K1 of 0.1 m/s is defined as the fracture toughness value K1c.

In the present specification, the term "semiconductor" may refer to not only a semiconductor wafer such as silicon or a semiconductor chip but also a composite including a chip, a wiring layer, and a mold resin.

In the present specification, a crack initiation load (CIL) refers to an indentation load of a Vickers indenter having a crack initiation rate of 50% when an indentation is formed using a Vickers indenter having a tip angle of 136° on a mirror-finished surface having a thickness of 0.7 mm or more.

(Measurement Method of CIL)

A sheet-shaped glass having a thickness of 0.7 mm in which both surfaces are mirror-polished is prepared. With a Vickers hardness tester, after the Vickers indenter is pressed for 15 seconds, the Vickers indenter is removed, and after 15 seconds, the number of generated cracks is observed from a corner of the indentation. The measurement is performed on 10 pieces of glass for each indentation load of the Vickers indenter of 10 gf, 25 gf, 50 gf, 100 gf, 200 gf, 300 gf, and 500 gf, and an average value of the number of generated cracks is calculated for each load. A relationship between the load and the number of cracks is regressed using a sigmoid function, and a load at which the number of cracks is two is defined as CIL (gf). An atmosphere condition of the measurement is that an air temperature is 25°C and a dew point is -40°C.

<Chemically Strengthened Glass>

The chemically strengthened glass of the present invention (hereinafter, also abbreviated as "the present strengthened glass") is typically a sheet-shaped glass article, and may have a flat sheet shape or a curved surface shape. In addition, portions having different thicknesses may be present in the glass. In addition, the chemically strengthened glass is a glass ceramic containing at least one of a $Li_3PO_4$ crystal and a $Li_4SiO_4$ crystal, or containing a solid solution crystal of $Li_3PO_4$ or $Li_4SiO_4$ or solid solutions of both $Li_3PO_4$ and $Li_4SiO_4$. The glass ceramic containing at least one of a $Li_3PO_4$ crystal and a $Li_4SiO_4$ crystal, or containing a solid solution crystal of $Li_3PO_4$ or $Li_4SiO_4$ or solid solutions of both $Li_3PO_4$ and $Li_4SiO_4$ will be described later.

When the present chemically strengthened glass has a sheet shape, the thickness (t) is preferably 3 mm or less, more preferably, in stages, 2 mm or less, 1.6 mm or less, 1.1 mm or less, 0.9 mm or less, 0.8 mm or less, and 0.7 mm or less. In order to obtain sufficient strength by the chemical strengthening treatment, the thickness (t) is preferably 0.3 mm or more, more preferably 0.4 mm or more, and still more preferably 0.5 mm or more.

A haze value in terms of a thickness of 0.7 mm of the present strengthened glass is preferably 0.5% or less. The haze value and the light transmittance of the present chemically strengthened glass are basically the same as those of the glass ceramics before the chemical strengthening, and thus will be explained in the section on the glass ceramics.

In the present strengthened glass, a surface compressive stress value ($CS_0$) is preferably 400 MPa or more, because it is less likely to break due to deformation such as bending. The $CS_0$ is more preferably 500 MPa or more, and still more preferably 600 MPa or more. The strength increases as the $CS_0$ increases. However, if the $CS_0$ is too large, severe fracturing may occur when the glass is cracked, and thus the $CS_0$ is preferably 1200 MPa or less, and more preferably 1000 MPa or less.

The DOL of the present strengthened glass is preferably 70 $\mu$m or more, because the present strengthened glass is not easily cracked even if flaws are formed on the surface. The DOL is more preferably 80 $\mu$m or more, still more preferably 90 $\mu$m or more, and particularly preferably 100 $\mu$m or more. The present strengthened glass is not easily cracked even if flaws are formed as the DOL increases. However, in the chemically strengthened glass, the tensile stress is generated inside in accordance with the compressive stress formed in the vicinity of the surface, and thus the DOL cannot be extremely increased. In the case of the thickness t, the DOL is preferably t/4 or less, and more preferably t/5 or less. The DOL is preferably 200 $\mu$m or less and more preferably 180 $\mu$m or less in order to shorten the time required for chemical strengthening.

The CT of the present strengthened glass is preferably 110 MPa or less, because scattering of broken pieces is prevented when the chemically strengthened glass is fractured. The CT is more preferably 100 MPa or less, and still more preferably 90 MPa or less. On the other hand, when the CT is reduced, the surface compressive stress is reduced, and it tends to be difficult to obtain sufficient strength. Therefore, the CT is preferably 50 MPa or more, more preferably 55 MPa or more, and still more preferably 60 MPa or more.

In order to increase anti-drop strength, the ST value of the present strengthened glass is preferably 18000 MPa·$\mu$m or more, more preferably 20000 MPa·$\mu$m or more, still more preferably 22000 MPa·$\mu$m or more, and most preferably 24000 MPa·$\mu$m or more. On the other hand, when the ST value is too large, the glass pieces scatter during fracturing, and thus, the ST value is preferably 30000 MPa·$\mu$m or less, more preferably 29000 MPa·$\mu$m or less, still more preferably 28000 MPa·$\mu$m or less, and most preferably 27000 MPa·$\mu$m or less.

In the present strengthened glass, a base composition preferably contains, in terms of mol% based on oxides:

40% to 70% of $SiO_2$;
10% to 35% of $Li_2O$; and
1% to 15% of $Al_2O_3$.

The base composition of the present strengthened glass more preferably contains:

40% to 70% of $SiO_2$;
10% to 35% of $Li_2O$;
1% to 15% of $Al_2O_3$;
0.5% to 5% of $P_2O_5$;
0.5% to 5% of $ZrO_2$;
0% to 10% of $B_2O_3$;
0% to 3% of $Na_2O$;
0% to 1% of $K_2O$; and
0% to 4% of $SnO_2$,
in which a total content of $SiO_2$, $Al_2O_3$, PzOs, and $B_2O_3$ is 60% to 80%.

Alternatively, the base composition of the present strengthened glass more preferably contains:

50% to 70% of $SiO_2$;
15% to 30% of $Li_2O$;
1% to 10% of $Al_2O_3$;
0.5% to 5% of $P_2O_5$;
0.5% to 8% of $ZrO_2$;
0.1% to 10% of MgO;
0% to 5% of $Y_2O_3$;
0% to 10% of $B_2O_3$;
0% to 3% of $Na_2O$;
0% to 1% of $K_2O$; and
0% to 2% of $SnO_2$.

Here, the "base composition of the chemically strengthened glass" refers to a composition of glass ceramics before chemical strengthening. The composition will be described later. The composition of the present strengthened glass has a composition similar to the composition of the glass ceramics before strengthening as a whole, except for a case where an extreme ion exchange treatment is performed. In particular, the composition of the deepest portion from the glass surface is the same as the composition of the glass ceramics before strengthening, except for a case where an extreme ion exchange treatment is performed.

The present strengthened glass is also useful as a cover glass used for electronic devices such as mobile devices such as mobile phones and smartphones, in addition to a semiconductor support substrate to be described later. Further, the present strengthened glass is also useful for a cover glass of an electronic device such as a television, a personal computer, and a touch panel, an elevator wall surface, or a wall surface (full-screen display) of a construction such as a house and a building, which is not intended to be carried. The present strengthened glass is also useful as a building material such as a window glass, a table top, an interior of an automobile, an airplane, or the like, and a cover glass thereof, or a casing having a curved surface shape. Glass ceramics before strengthening and an amorphous glass before crystallization are also useful for the semiconductor support substrate.

The semiconductor support substrate is a substrate used in the field of semiconductor packages. In the field of semiconductor packages, the technique such as wafer-level packaging (WLP) or panel level packaging (PLP) has attracted attention in manufacturing (see Asahi Glass Research Report, vol. 67 (2017)). The technique is, for example, a technique of sealing by placing a silicon chip on a glass substrate and molding the silicon chip with a sealing resin.

In this case, the support substrate may be peeled off to be used during the manufacturing process. A glass substrate is widely used as the support substrate. Since the glass substrate is transparent, the glass substrate can be peeled off by irradiation with laser light. The glass substrate used as the support substrate is required to reduce warpage due to thermal expansion matching with a semiconductor. Further, it is also required that the glass substrate is not likely to be broken during the packaging process and that the broken pieces do not scatter when the glass substrate is broken.

<Glass Ceramics>

The present glass ceramics preferably contain at least one of a $Li_3PO_4$ crystal and a $Li_4SiO_4$ crystal. When having these crystals as main crystals, the light transmittance increases, and the haze decreases.

The present glass ceramics may contain both a $Li_3PO_4$ crystal and a $Li_4SiO_4$ crystal. Either one may be contained as a main crystal. Solid solution crystals of $Li_3PO_4$ and $Li_4SiO_4$ may be contained as main crystals. A solid solution crystal of either $Li_3PO_4$ or $Li_4SiO_4$ may be contained as a main crystal.

Since the $Li_2SiO_3$ crystal is not excellent in chemical resistance, it is preferable not to contain the $Li_2SiO_3$ crystal.

Since the $Li_3PO_4$ crystal and the $Li_4SiO_4$ crystal have similar crystal structures, it may be difficult to determine by powder X-ray diffraction measurement. That is, when powder X-ray diffraction is measured, diffraction peaks appear around $2\theta = 16.9°, 22.3°, 23.1°$, and $33.9°$. Since the crystal amount may be small or may be oriented, a peak with low intensity or a peak of a specific crystal plane may not be confirmed. In addition, when both crystals are dissolved in solid solution, a peak position may shift by about $2\theta$ of $1°$.

In the present glass ceramics, when the X-ray diffraction is measured in a range of $2\theta = 10°$ to $80°$, a strongest diffraction peak preferably appears at $22.3° \pm 0.2°$ or $23.1° \pm 0.2°$.

In order to increase the mechanical strength, a crystallization rate of the present glass ceramics is preferably 5% or more, more preferably 10% or more, still more preferably 15% or more, and particularly preferably 20% or more. In order to improve the transparency, the crystallization rate is preferably 70% or less, more preferably 60% or less, and still more preferably 50% or less. A small crystallization rate is also excellent in view of facilitating bending forming by heating.

In order to increase the strength, an average grain size of precipitated crystals of the present glass ceramics is preferably 5 nm or more, and particularly preferably 10 nm or more. In order to enhance the transparency, the average grain size is preferably 80 nm or less, more preferably 60 nm or less, still more preferably 50 nm or less, particularly preferably 40 nm or less, and most preferably 30 nm or less. The average grain size of the precipitated crystals is determined from a transmission electron microscope (TEM) image or an FE-SEM image.

When the present glass ceramics has a sheet shape, the thickness (t) is preferably 3 mm or less, more preferably, in stages, 2 mm or less, 1.6 mm or less, 1.1 mm or less, 0.9 mm or less, 0.8 mm or less, and 0.7 mm or less. In order to obtain sufficient strength by the chemical strengthening treatment, the thickness (t) is preferably 0.3 mm or more, more preferably 0.4 mm or more, and still more preferably 0.5 mm or more.

The light transmittance of the present glass ceramics is 85% or more when the thickness is 0.7 mm. Therefore, a screen of a display can be easily seen when the present glass ceramics are used as a cover glass of a portable display. The light transmittance is preferably 88% or more, and more preferably 90% or more. The light transmittance is preferably as high as possible, but is generally 91% or less. When the thickness is 0.7 mm, the light transmittance of 90% is equivalent to that of an ordinary amorphous glass.

When an actual thickness is not 0.7 mm, the light transmittance in the case of 0.7 mm can be calculated from Lambert-Beer law based on a measured value. When the sheet thickness t is larger than 0.7 mm, the measurement may be performed by adjusting the sheet thickness to 0.7 mm by polishing, etching, or the like.

When the thickness is 0.7 mm, the haze value is 0.5% or less, preferably 0.3% or less, more preferably 0.2% or less, still more preferably 0.15% or less, particularly preferably 0.1% or less, most preferably 0.08% or less, and extremely preferably 0.05% or less. The haze value is preferable as small as possible, but the haze value is generally 0.01% or more. When the thickness is 0.7 mm, the haze value of 0.02% is equivalent to that of an ordinary amorphous glass.

When the total visible light transmittance of the glass ceramics having a sheet thickness t [mm] is $100 \times T$ [%], and the haze value is $100 \times H$ [%], $T = (1 - R)^2 \times \exp(-\alpha t)$ can be established using a constant $\alpha$ by incorporating the Lambert-Beer law. Using this constant $\alpha$, the following can be obtained: $dH / dt \propto \exp(-\alpha t) \times (1 - H)$.

That is, the haze value can be considered to increase by an amount proportional to the internal linear transmittance as the sheet thickness increases, and thus a haze value $H_{0.7}$ in the case of 0.7 mm is determined by the following formula.

[Equation 1]

$$H_{0.7} = 100 \times \left[ 1 - (1-H)^{\{((1-R)^2 - T_{0.7}) / (1-R)^2 - T)\}} \right] \quad [\%]$$

When the sheet thickness t is larger than 0.7 mm, the measurement may be performed by adjusting the sheet thickness to 0.7 mm by polishing, etching, or the like.

The ST limit of the present glass ceramics is preferably 18000 MPa·$\mu$m or more. In order to increase the anti-drop strength by chemical strengthening, the ST limit is more preferably 19000 MPa·$\mu$m or more, and still more preferably 20000 MPa·$\mu$m or more. Since the present glass ceramics have a large ST limit, the glass ceramics are less likely to be fractured even if the glass ceramics have high strength by chemical strengthening. The ST limit is preferably as large as possible, but is generally 30000 MPa·$\mu$m or less.

The present glass ceramics are obtained by heating and crystallizing an amorphous glass to be described later.

The present glass ceramics preferably contain, in terms of mol% based on oxides:

40% to 70% of $SiO_2$;
10% to 35% of $Li_2O$;
1% to 15% of $Al_2O_3$;
0.5% to 5% of $P_2O_5$;
0.5% to 5% of $ZrO_2$;
0% to 10% of $B_2O_3$;
0% to 3% of $Na_2O$;
0% to 1% of $K_2O$; and
0% to 4% of $SnO_2$.

In the present specification, the glass ceramics having such a composition are also referred to as "the present glass ceramics A".

Alternatively, the present glass ceramics preferably contain, in terms of mol% based on oxides:

50% to 70% of $SiO_2$;
15% to 30% of $Li_2O$;
1% to 10% of $Al_2O_3$;
0.5% to 5% of $P_2O_5$;
0.5% to 8% of $ZrO_2$;
0.1% to 10% of $MgO$;
0% to 5% of $Y_2O_3$;
0% to 10% of $B_2O_3$;
0% to 3% of $Na_2O$;
0% to 1% of $K_2O$; and
0% to 2% of $SnO_2$.

In the present specification, the glass ceramics having such a composition are also referred to as "the present glass ceramics B".

In the present glass ceramics, a total content of $SiO_2$, $Al_2O_3$, $PzOs$, and $B_2O_3$ is preferably 60% to 80% in terms of mol% based on oxides. $SiO_2$, $Al_2O_3$, $PzOs$, and $B_2O_3$ are network formers of the glass (hereinafter, also abbreviated as "NWF"). When the total content of these NWF increases, the strength of the glass increases. Accordingly, since the fracture toughness value of the glass ceramics is increased, the total content of the NWF is preferably 60% or more, more preferably 63% or more, and particularly preferably 65% or more. However, when the content of NWF is too large, a melt temperature of the glass is increased, and thus, the manufacturing of the glass becomes difficult. The total content of the NWF is preferably 80% or less, more preferably 75% or less, and still more preferably 70% or less.

In the present glass ceramics, a ratio of the total content of $Li_2O$, $Na_2O$, and $K_2O$ to the total content of NWF, that is, $SiO_2$, $Al_2O_3$, $P_2O_5$, and $B_2O_3$ is preferably 0.20 to 0.60. As for the semiconductor support substrate, when a ratio $Al_2O_3$ / $Li_2O$ of the content of $Al_2O_3$ to $Li_2O$ is 0.0029 to 0.0075 with respect to the total content of NWF, it is possible to increase the Young's modulus while maintaining a suitable thermal expansion coefficient as a support substrate of a semiconductor package having a large amount of resin components, and it is possible to reduce warpage in a packaging process. The lower limit is preferably 0.0031 or more, more preferably 0.0032 or more, and the upper limit is preferably 0.0064 or less, more preferably 0.0051 or less. As a component for increasing the Young's modulus, $Al_2O_3$ is most effective, and other examples thereof include $MgO$, $ZrO_2$, $Y_2O_3$, $Ga_2O_3$, $BeO$, $TiO_2$, and $Ta_2O_5$.

$Li_2O$, $Na_2O$, and $K_2O$ are network modifiers, and reducing the ratio to NWF increases voids in the network and thus improves impact resistance. Therefore, the ratio of the total content of $Li_2O$, $Na_2O$, and $K_2O$ to the total content of NWF, that is, $SiO_2$, $Al_2O_3$, $P_2O_5$, and $B_2O_3$ is preferably 0.60 or less, more preferably 0.55 or less, and particularly preferably 0.50 or less. On the other hand, since these are components necessary for chemical strengthening, the ratio of the total content of $Li_2O$, $Na_2O$, and $K_2O$ to the total content of NWF, that is, $SiO_2$, $Al_2O_3$, $P_2O_5$, and $B_2O_3$ is preferably 0.20 or more, more preferably 0.25 or more, and particularly preferably 0.30 or more, in order to improve chemical strengthening properties.

Hereinafter, the glass composition will be described.

In the present amorphous glass, $SiO_2$ is a component that forms a network structure of a glass. $SiO_2$ is a component that increases chemical durability, and the content of $SiO_2$ is preferably 40% or more. The content of $SiO_2$ is more preferably 45% or more, still more preferably 50% or more, particularly preferably 52% or more, and extremely preferably 54% or more. On the other hand, in order to improve the meltability, the content of $SiO_2$ is preferably 70% or less, more preferably 68% or less, still more preferably 66% or less, and particularly preferably 64% or less.

$Al_2O_3$ is a component that increases a surface compressive stress due to chemical strengthening, and is essential. The content of $Al_2O_3$ is preferably 1% or more, more preferably 2% or more, still more preferably, in the following order, 3% or more, 5% or more, 5.5% or more, 6% or more, particularly preferably 6.5% or more, and most preferably 7% or more. In order to prevent a devitrification temperature of the glass from being too high, the content of $Al_2O_3$ is preferably 15% or less, more preferably 12% or less, still more preferably 10% or less, particularly preferably 9% or less, and most preferably 8% or less.

$Li_2O$ is a component that forms a surface compressive stress by ion exchange, and is a constituent component of the main crystal, and thus is essential. The content of $Li_2O$ is preferably 10% or more, more preferably 14% or more, still more preferably 15% or more, yet still more preferably 18% or more, particularly preferably 20% or more, and most preferably 22% or more. Further, in order to stabilize the glass, the content of $Li_2O$ is preferably 35% or less, more preferably 32% or less, still more preferably 30% or less, particularly preferably 28% or less, and most preferably 26% or less.

$Na_2O$ is a component that improves meltability of the glass. $Na_2O$ is not essential, but in a case where $Na_2O$ is contained, the content of $Na_2O$ is preferably 0.5% or more, more preferably 1% or more, and particularly preferably 2% or more. When the content of $Na_2O$ is too high, crystals are less likely to be precipitated or chemical strengthening properties are deteriorated, and thus, the content of $Na_2O$ is preferably 3% or less, more preferably 2.5% or less, still more preferably 2% or less, and particularly preferably 1.5% or less.

$K_2O$ is a component that lowers a melting temperature of the glass similarly to $Na_2O$, and may be contained. In a case where $K_2O$ is contained, the content of $K_2O$ is preferably 0.5% or more, more preferably 0.8% or more, and still more preferably 1% or more. When the content of $K_2O$ is too high, the chemical strengthening properties are deteriorated or the chemical durability is deteriorated, and thus, the content of $K_2O$ is preferably 1% or less, more preferably 0.8% or less, still more preferably 0.6% or less, particularly preferably 0.5% or less, and most preferably 0.4% or less.

In order to improve the meltability of glass raw materials, the total content $Na_2O + K_2O$ of $Na_2O$ and $K_2O$ is preferably 1% or more, and more preferably 2% or more.

In addition, a ratio $K_2O$ / $R_2O$ of the content of $K_2O$ to the total content (hereinafter, $R_2O$) of $Li_2O$, $Na_2O$, and $K_2O$ is preferably 0.2 or less, because the chemical strengthening properties are enhanced and the chemical durability can be enhanced. $K_2O$ / $R_2O$ is more preferably 0.15 or less, and still more preferably 0.10 or less.

$R_2O$ is preferably 10% or more, more preferably 15% or more, and still more preferably 20% or more. In addition, $R_2O$ is preferably 29% or less, and more preferably 26% or less.

$P_2O_5$ is a constituent component of the $Li_3PO_4$ crystal, and is essential. In order to promote the crystallization, the content of $P_2O_5$ is preferably 0.5% or more, more preferably 1% or more, still more preferably 1.5% or more, particularly preferably 2% or more, and extremely preferably 2.5% or more. On the other hand, when the content of $P_2O_5$ is too high, phase separation tends to occur during melting, and the acid resistance is significantly reduced, and thus the content of $P_2O_5$ is preferably 5% or less, more preferably 4.8% or less, still more preferably 4.5% or less, and particularly preferably 4.2% or less.

$ZrO_2$ is a component that enhances mechanical strength and chemical durability, and remarkably improves the CS, and thus is preferably contained. The content of $ZrO_2$ is preferably 0.5% or more, more preferably 1% or more, still more preferably 1.5% or more, particularly preferably 2% or more, and most preferably 2.5% or more. On the other hand, in order to prevent devitrification during melting, $ZrO_2$ is preferably 8% or less, more preferably 7.5% or less, still more preferably 7% or less, and particularly preferably 6% or less. When the content of $ZrO_2$ is too high, the viscosity decreases due to an increase in devitrification temperature. In order to prevent deterioration of moldability due to such a decrease in viscosity, when the molding viscosity is low, the content of $ZrO_2$ is preferably 5% or less, more preferably 4.5% or less, and still more preferably 3.5% or less.

In order to increase the chemical durability, $ZrO_2$ / $R_2O$ is preferably 0.02 or more, more preferably 0.03 or more, still more preferably 0.04 or more, particularly preferably 0.1 or more, and most preferably 0.15 or more. In order to increase the transparency after crystallization, $ZrO_2$ / $R_2O$ is preferably 0.6 or less, more preferably 0.5 or less, still more preferably 0.4 or less, and particularly preferably 0.3 or less.

MgO is a component that stabilizes the glass, and is also a component that enhances mechanical strength and chemical resistance, and thus, it is preferable to contain MgO when the content of $Al_2O_3$ is relatively small. The content of MgO is preferably 1% or more, more preferably 2% or more, still more preferably 3% or more, and particularly preferably 4% or more. On the other hand, when MgO is excessively added, the viscosity of the glass decreases and devitrification or phase separation is likely to occur, and thus the content of MgO is preferably 10% or less, more preferably 9% or less, still more preferably 8% or less, and particularly preferably 7% or less.

$TiO_2$ is a component capable of promoting crystallization and may be contained. $TiO_2$ is not essential, but in a case where $TiO_2$ is contained, the content of $TiO_2$ is preferably 0.2% or more, and more preferably 0.5% or more. On the other hand, in order to prevent devitrification during melting, the content of $TiO_2$ is preferably 4% or less, more preferably 2% or less, and still more preferably 1% or less.

$SnO_2$ has an action of promoting the generation of crystal nuclei, and may be contained. $SnO_2$ is not essential, but in a case where $SnO_2$ is contained, the content of $SnO_2$ is preferably 0.5% or more, more preferably 1% or more, still more preferably 1.5% or more, and particularly preferably 2% or more. In order to prevent devitrification during melting, the content of $SnO_2$ is preferably 4% or less, more preferably 3.5% or less, still more preferably 3% or less, and particularly preferably 2.5% or less.

$Y_2O_3$ is a component having an effect of preventing scattering of broken pieces when the chemically strengthened glass is fractured, and may be contained. The content of $Y_2O_3$ is preferably 1% or more, more preferably 1.5% or more, still more preferably 2% or more, particularly preferably 2.5% or more, and extremely preferably 3% or more. On the other hand, in order to prevent devitrification during melting, the content of $Y_2O_3$ is preferably 5% or less, and more preferably 4% or less.

$B_2O_3$ is a component that improves chipping resistance of the glass for chemical strengthening or the chemically strengthened glass and improves meltability, and may be contained. In a case where $B_2O_3$ is contained, in order to improve the meltability, the content of $B_2O_3$ is preferably 0.5% or more, more preferably 1% or more, and still more preferably 2% or more. On the other hand, when the content of $B_2O_3$ is too high, striae occurs during melting, and phase separation easily occurs, resulting in deterioration in the quality of the glass for chemical strengthening. Therefore, the content of $B_2O_3$ is preferably 10% or less. The content of $B_2O_3$ is more preferably 8% or less, still more preferably 6% or less, and particularly preferably 4% or less.

BaO, SrO, MgO, CaO, and ZnO are all components that improve the meltability of the glass, and may be contained. When these components are contained, the total content of BaO, SrO, MgO, CaO and ZnO (hereinafter, BaO + SrO + MgO + CaO + ZnO) is preferably 0.5% or more, more preferably 1% or more, still more preferably 1.5% or more, and particularly preferably 2% or more. Further, since an ion exchange rate decreases, BaO + SrO + MgO + CaO + ZnO is preferably 8% or less, more preferably 6% or less, still more preferably 5% or less, and particularly preferably 4% or less.

Among these, BaO, SrO, and ZnO may be contained in order to improve a refractive index of a residual glass and bring the residual glass closer to a precipitated crystal phase, thereby improving the light transmittance of the glass ceramics and lowering the haze value. In this case, the total content of BaO, SrO, and ZnO (hereinafter, BaO + SrO + ZnO) is preferably 0.3% or more, more preferably 0.5% or more, still more preferably 0.7% or more, and particularly preferably 1% or more. On the other hand, these components may decrease the ion exchange rate. In order to improve the chemical strengthening properties, BaO + SrO + ZnO is preferably 2.5% or less, more preferably 2% or less, still more preferably 1.7% or less, and particularly preferably 1.5% or less.

$La_2O_3$, $Nb_2O_5$, and $Ta_2O_5$ are all components that prevent scattering of broken pieces when the chemically strengthened glass is fractured, and may be contained to increase the refractive index. When these components are contained, the total content of $La_2O_3$, $Nb_2O_5$ and $Ta_2O_5$ (hereinafter, $La_2O_3 + Nb_2O_5 + Ta_2O_5$) is preferably 0.5% or more, more preferably 1% or more, still more preferably 1.5% or more, and particularly preferably 2% or more. In order to make the glass less likely to be devitrified during melting, $La_2O_3 + Nb_2O_5 + Ta_2O_5$ is preferably 4% or less, more preferably 3% or less, still more preferably 2% or less, and particularly preferably 1% or less.

In addition, CeOz may be contained. CeOz may prevent coloring by oxidizing the glass. In a case where CeOz is contained, the content of $CeO_2$ is preferably 0.03% or more, more preferably 0.05% or more, and still more preferably 0.07% or more. In order to increase the transparency, the content of $CeO_2$ is preferably 1.5% or less, and more preferably 1.0% or less.

When the strengthened glass is colored to be used, coloring components may be added within a range that does not inhibit the achievement of desired chemical strengthening properties. Examples of the coloring components include $Co_3O_4$, $MnO_2$, $Fe_2O_3$, NiO, CuO, CrzOs, $V_2O_5$, $Bi_2O_3$, $SeO_2$, $Er_2O_3$, $Nd_2O_3$, and the like.

The total content of coloring components is preferably in the range of 1% or less. In a case where it is desired to further increase the visible light transmittance of the glass, it is preferable that these components are not substantially contained.

In order to increase the weather resistance against ultraviolet light irradiation, $HfO_2$, $Nb_2O_5$, and $Ti_2O_3$ may be added. When $HfO_2$, $Nb_2O_5$, and $Ti_2O_3$ are added for the purpose of increasing the weather resistance against ultraviolet light irradiation, in order to reduce the influence on other properties, the total content of $HfO_2$, $Nb_2O_5$, and $Ti_2O_3$ is preferably 1% or less, more preferably 0.5% or less, and still more preferably 0.1% or less.

$SO_3$, a chloride, and a fluoride may be appropriately contained as a refining agent during melting of the glass. Since the components functioning as the refining agent affect the strengthening properties and crystallization behavior when added in excess, the total content of the components is preferably 2% or less, more preferably 1% or less, and still more preferably 0.5% or less in terms of mass% based on oxides. The lower limit is not particularly limited, but is typically preferably 0.05% or more in total in terms of mass% based on oxides.

In a case where $SO_3$ is used as the refining agent, when the content of $SO_3$ is too low, no effect is observed, and thus the content of $SO_3$ is preferably 0.01% or more, more preferably 0.05% or more, and still more preferably 0.1% or more in terms of mass% based on oxides. Further, when $SO_3$ is used as the refining agent, the content of $SO_3$ is preferably 1% or less, more preferably 0.8% or less, and still more preferably 0.6% or less in terms of mass% based on oxides.

In a case where Cl is used as the refining agent, Cl affects physical properties such as strengthening properties when added excessively, and thus the content of Cl is preferably 1% or less, more preferably 0.8% or less, and still more preferably 0.6% or less in terms of mass% based on oxides. Further, in a case where Cl is used as the refining agent, when the content of Cl is too low, no effect is observed, and thus the content of Cl is preferably 0.05% or more, more preferably 0.1% or more, and still more preferably 0.2% or more in terms of mass% based on oxides.

In a case where $SnO_2$ is used as the refining agent, $SnO_2$ affects the crystallization behavior when added excessively, and thus the content of $SnO_2$ is preferably 1% or less, more preferably 0.5% or less, and still more preferably 0.3% or less in terms of mass% based on oxides. Further, in a case where $SnO_2$ is used as the refining agent, when the content of $SnO_2$ is too low, no effect is observed, and thus the content of $SnO_2$ is preferably 0.02% or more, more preferably 0.05% or more, and still more preferably 0.1% or more in terms of mass% based on oxides.

$As_2O_3$ is preferably not contained. When $Sb_2O_3$ is contained, the content of $Sb_2O_3$ is preferably 0.3% or less, more preferably 0.1% or less, and it is most preferable that $Sb_2O_3$ is not contained.

The present glass ceramics have a large fracture toughness value and are less likely to cause severe fracturing even when a large compressive stress is formed by chemical strengthening. When the fracture toughness value of the present glass ceramics is preferably 0.81 MPa·m$^{1/2}$ or more, more preferably 0.83 MPa·m$^{1/2}$ or more, and still more preferably 0.85 MPa·m$^{1/2}$ or more, a glass with high impact resistance can be obtained. The upper limit of the fracture toughness value of the present glass ceramics is not particularly limited, but is typically 1.5 MPa·m$^{1/2}$ or less.

In order to prevent warpage during chemical strengthening treatment, a Young's modulus of the present glass ceramics is preferably 80 GPa or more, more preferably 85 GPa or more, still more preferably 90 GPa or more, and particularly preferably 95 GPa or more. The present glass ceramics may be used after being polished. For ease of polishing, the Young's modulus is preferably 130 GPa or less, more preferably 120 GPa or less, and still more preferably 110 GPa or less.

When the Young's modulus of the amorphous glass is 80 GPa or more, warpage can be prevented even in a state of the amorphous glass, and thus the glass is suitable for a support substrate for a semiconductor. The Young's modulus is preferably 85 GPa or more, more preferably 90 GPa or more, and still more preferably 95 GPa or more. For ease of polishing, the Young's modulus is preferably 130 GPa or less, more preferably 120 GPa or less, and still more preferably 110 GPa or less.

The indentation load value (CIL) at which the number of cracks in the present glass ceramic is two is preferably 50 gf or more, more preferably 100 gf or more, still more preferably 150 gf or more, and most preferably 200 gf or more, from the viewpoint of preventing the initiation of cracks at dropping.

<Amorphous Glass>

The present glass ceramics are obtained by subjecting an amorphous glass (amorphous glass according to the present invention) to be described below to a heat treatment. The composition of the amorphous glass according to the present invention is the same as the composition of the above described present glass ceramics.

The amorphous glass according to the present invention (hereinafter, also abbreviated as "the present amorphous glass") preferably contains, in terms of mol% based on oxides, $SiO_2$ in an amount of 40% to 70%, $Li_2O$ in an amount of 10% to 35%, and $Al_2O_3$ in an amount of 1% to 15%.

Examples of the preferable composition of the present amorphous glass include a composition containing, in terms of mol% based on oxides, $SiO_2$ in an amount of 40% to 70%, $Li_2O$ in an amount of 10% to 35%, $Al_2O_3$ in an amount of 1% to 15%, $P_2O_5$ in an amount of 0.5% to 5%, $ZrO_2$ in an amount of 0.5% to 5%, $B_2O_3$ in an amount of 0% to 10%, $Na_2O$ in an amount of 0% to 3%, $K_2O$ in an amount of 0% to 1%, and $SnO_2$ in an amount of 0% to 4%.

Alternatively, examples of the preferable composition of the present amorphous glass include a composition containing, in terms of mol% based on oxides, $SiO_2$ in an amount of 50% to 70%, $Li_2O$ in an amount of 15% to 30%, $Al_2O_3$ in an amount of 1% to 10%, $P_2O_5$ in an amount of 0.5% to 5%, $ZrO_2$ in an amount of 0.5% to 8%, MgO in an amount of 0.1% to 10%, $Y_2O_3$ in an amount of 0% to 5%, $B_2O_3$ in an amount of 0% to 10%, $Na_2O$ in an amount of 0% to 3%, $K_2O$ in an amount of 0% to 1%, and $SnO_2$ in an amount of 0% to 2%.

In the present amorphous glass, a total content of $SiO_2$, $Al_2O_3$, $P_2O_5$, and $B_2O_3$ is preferably 60% to 80%. A ratio of the total content of $Li_2O$, $Na_2O$, and $K_2O$ to the total content of $SiO_2$, $Al_2O_3$, $P_2O_5$, and $B_2O_3$ is preferably 0.20 to 0.60.

In order not to cause structural relaxation during chemical strengthening, a glass transition point Tg of the present amorphous glass is preferably 400°C or higher, more preferably 450°C or higher, and still more preferably 500°C or higher. In addition, the glass transition point Tg is preferably 650°C or lower, and more preferably 600°C or lower.

A difference (Tx - Tg) between the glass transition point (Tg) determined from a DSC curve obtained by pulverizing the present amorphous glass and using a differential scanning calorimeter and a crystallization starting temperature (Tx) appearing in the lowest temperature region in the DSC curve is preferably 50°C or higher, more preferably 60°C or higher, still more preferably 70°C or higher, and particularly preferably 80°C or higher. When (Tx - Tg) is large, the glass ceramics are easily bent by reheating.

An average thermal expansion coefficient of the present amorphous glass at 50°C to 350°C is preferably 70 $\times$ 10$^{-7}$°C or higher, more preferably 75 $\times$ 10$^{-7}$°C or higher, and most preferably 80 $\times$ 10$^{-7}$°C or higher.

When the thermal expansion coefficient is too large, cracking may occur due to a difference in thermal expansion in a process of chemical strengthening, and thus, the thermal expansion coefficient is preferably 120 $\times$ 10$^{-7}$°C or lower, more preferably 110 $\times$ 10$^{-7}$°C or lower, and still more preferably 100 $\times$ 10$^{-7}$°C or lower.

When the present amorphous glass has such a thermal expansion coefficient, the present amorphous glass is suitable as a support substrate of a semiconductor package having a large amount of resin components.

<Method for Producing Chemically Strengthened Glass>

The chemically strengthened glass of the present invention is produced by chemically strengthening glass ceramics. The glass ceramics are produced by a method of crystallizing the above amorphous glass by a heat treatment.

(Production of Amorphous Glass)

The amorphous glass can be produced, for example, by the following method. The production method described below is an example in which a sheet-shaped chemically strengthened glass is produced.

Glass raw materials are blended so as to obtain a glass having a preferable composition, and the glass raw materials are heated and melted in a glass melting furnace. Thereafter, the molten glass is homogenized by bubbling, stirring, addition of a refining agent, or the like, formed into a glass sheet having a predetermined thickness by a known forming method, and then annealed. Alternatively, the molten glass may be formed into a sheet shape by a method of forming the molten glass into a block shape, annealing and then cutting.

(Crystallization Treatment)

Glass ceramics are obtained by subjecting the amorphous glass obtained by the above procedure to a heat treatment (for example, preferably 450°C or higher and 800°C or lower).

The heat treatment may be performed in two stages in which the temperature is increased from room temperature to a first treatment temperature, and the amorphous glass is held for a certain period of time, and then the amorphous glass is held for a certain period of time at a second treatment temperature that is higher than the first treatment temperature. Alternatively, the heat treatment may be performed in one stage in which the amorphous glass is held at a specific treatment temperature and then cooled to room temperature.

In the case of the two-stage heat treatment, the first treatment temperature is preferably a temperature range in which a crystal nucleation rate increases in the glass composition, and the second treatment temperature is preferably a temperature range in which the crystal growth rate increases in the glass composition. A holding time at the first treatment temperature is preferably kept long so that a sufficient number of crystal nuclei are generated. When a large number of crystal nuclei are formed, the size of each crystal is reduced, and glass ceramics having high transparency are obtained.

In the case of the two-stage treatment, for example, the glass is held at the first treatment temperature of 450°C to 700°C for 1 hour to 6 hours, and then, the glass is held at the second treatment temperature of 600°C to 800°C for 1 hour to 6 hours. In the case of the one-stage treatment, for example, the glass is held at 500°C to 800°C for 1 hour to 6 hours.

The molten glass may be homogenized and formed into a glass sheet having a predetermined thickness, or the molten glass may be formed into a block shape and subsequently subjected to continuous crystallization treatment.

When the sheet-shaped glass is subjected to a heat treatment, examples of a setter plate include a silicon carbide plate, a silicon nitride plate, a SiN plate, an alumina plate, a mullite cordierite plate, a mullite plate, and a glass ceramic plate. In addition, a material having a high thermal conductivity is preferable in order to reduce temperature unevenness during heat treatment. The thermal conductivity of the setter plate is preferably 2 W/(m·K) or more, more preferably 20 W/(m·K) or more, and still more preferably 40 W/(m K) or more.

A release agent can be used in order to prevent the glass from sticking to the setter plate. Examples of the release agent include alumina cloth and glass cloth. Examples of the release agent include powdery boron nitride, alumina, and a mineral. The powdery release agent may be mixed with a solvent and coated with a spray or the like. When a particulate release agent is used, an average grain size is preferably 80 $\mu$m or less, more preferably 50 $\mu$m or less, and still more preferably 30 $\mu$m or less.

When the glass is subjected to a heat treatment, the glass may be laminated in order to increase working efficiency. When laminated, it is preferable to use a release agent between the glass and the glass. Further, a setter plate may be placed between the glass and the glass.

The glass ceramics obtained by the above procedure are subjected to a grinding and polishing treatment as necessary to form a glass ceramic sheet. When cutting the glass ceramic sheet into a predetermined shape and size, or performing chamfering on the glass ceramic sheet, it is preferable that the glass ceramic sheet is cut or subjected to chamfering before the chemical strengthening treatment is performed because a compressive stress layer is also formed on an end surface by a subsequent chemical strengthening treatment.

(Chemical Strengthening Treatment)

The chemical strengthening treatment is a treatment in which, by a method of immersing a glass into a melt of a metal salt (for example, potassium nitrate) containing metal ions (typically, Na ions or K ions) having a large ionic radius, the glass is brought into contact with the metal salt, and thus metal ions having a small ionic radius (typically, Na ions or Li ions) in the glass are substituted with the metal ions having a large ionic radius (typically, Na ions or K ions for Li ions, and K ions for Na ions).

In order to increase a rate of the chemical strengthening treatment, it is preferable to use "Li-Na exchange" in which Li ions in the glass are exchanged with Na ions. In addition, in order to form a large compressive stress by ion exchange, it is preferable to use "Na-K exchange" in which Na ions in the glass are exchanged with K ions.

Examples of the molten salt for performing the chemical strengthening treatment include a nitrate, a sulfate, a carbonate, and a chloride. Examples of the nitrate include lithium nitrate, sodium nitrate, potassium nitrate, cesium nitrate, and silver nitrate. Examples of the sulfate include lithium sulfate, sodium sulfate, potassium sulfate, cesium sulfate, and silver sulfate. Examples of the carbonate include lithium carbonate, sodium carbonate, and potassium carbonate. Examples of the chloride include lithium chloride, sodium chloride, potassium chloride, cesium chloride, and silver chloride. One of these molten salts may be used alone, or a plurality thereof may be used in combination.

As treatment conditions of the chemical strengthening treatment, time, temperature, and the like can be selected in consideration of the glass composition, the type of molten salt, and the like. For example, the present glass ceramics are subjected to the chemical strengthening treatment at preferably 450°C or lower for preferably 1 hour or less. Specifically, for example, a treatment is exemplified in which the present glass ceramics are immersed in a molten salt (for example, a mixed salt of lithium nitrate and sodium nitrate) containing preferably 0.3% by mass of Li and 99.7% by mass of Na at 450°C for preferably about 0.5 hours.

The chemical strengthening treatment may be performed by, for example, two-stage ion exchange as follows.

First, the present glass ceramics are preferably immersed in a metal salt (for example, sodium nitrate) containing Na ions at about 350°C to 500°C for about 0.1 to 10 hours. Accordingly, ion exchange between Li ions in the glass ceramics and Na ions in the metal salt occurs, and a relatively deep compressive stress layer can be formed.

Next, the present glass ceramics are preferably immersed in a metal salt (for example, potassium nitrate) containing K ions at about 350°C to 500°C for about 0.1 to 10 hours. Accordingly, a large compressive stress is generated in a portion of the compressive stress layer formed in the previous treatment, for example, within a depth of about 10 $\mu$m. According to such two-stage treatment, a stress profile having a large surface compressive stress value is easily obtained.

<Semiconductor Support Substrate>

A semiconductor support substrate (hereinafter, also referred to as a support glass) of the present invention will be described. The semiconductor support substrate of the present invention includes the amorphous glass and glass ceramic of the present invention. In order to increase the strength, the semiconductor support substrate more preferably includes the strengthened glass of the present invention.

The present amorphous glass, the glass ceramic, or the present strengthened glass has a large thermal expansion coefficient, and thus is suitable for a support substrate for fan-out packaging. In fan-out packaging, a package body having various average thermal expansion coefficients is formed depending on a ratio between a semiconductor chip and a resin component. However, in recent years, it is required to increase the fluidity of the mold resin and reduce the short shot, and thus a package body having a large amount of resin components and a high average thermal expansion coefficient is often used.

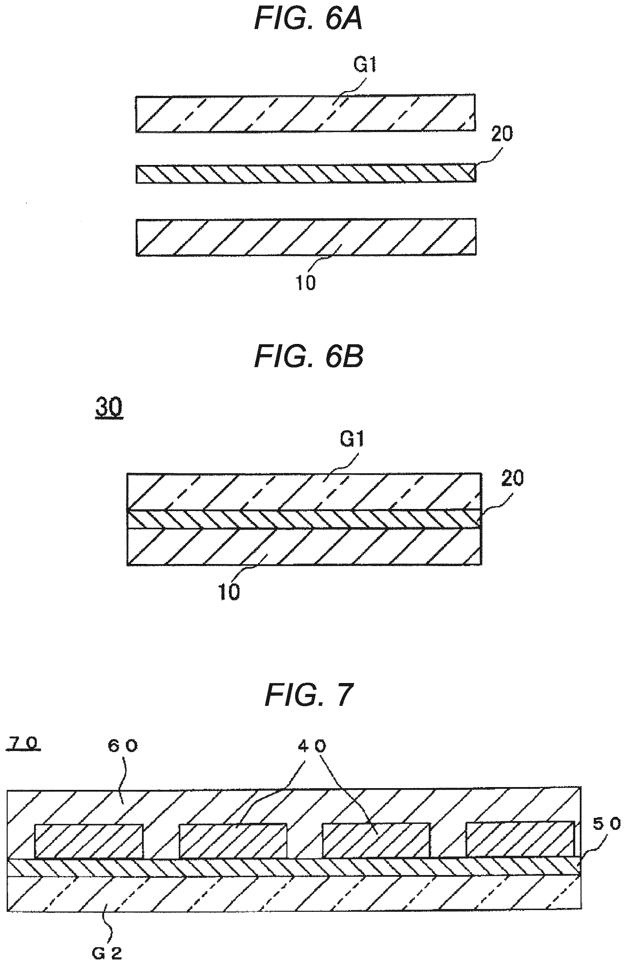

FIG. 6A and FIG. 6B are an example of a cross-sectional view of a support glass bonded to a semiconductor substrate. A support glass G1 shown in FIG. 6A is bonded to a semiconductor substrate 10 via a release layer 20 (which may function as a bonding layer) at a temperature of, for example, 200°C to 400°C to obtain a laminated substrate 30 shown in FIG. 6B. As the semiconductor substrate 10, for example, a full-sized semiconductor wafer, a semiconductor chip, a substrate in which a semiconductor chip is molded into a resin, a wafer in which an element is formed, or the like is used. The release layer 20 is, for example, a resin capable of withstanding a temperature of 200°C to 400°C.

The support substrate is used by being bonded to a semiconductor substrate. The support substrate is used for, for example, a support glass for fan-out wafer level packaging, a support glass for image sensors such as MEMS, CMOS, and CIS, which are effective for miniaturization of elements by wafer level packaging, a support glass (glass interposer; GIP) having a through hole, a support glass for back grinding of semiconductors, and the like. The support glass is particularly suitable as a support glass for fan-out wafer level packaging and panel level packaging.

FIG. 7 is an example of a cross-sectional view of a laminated substrate using the present support glass as a support substrate for fan-out wafer level packaging.

In the fan-out wafer level packaging, for example, a support glass G2 and a semiconductor substrate 40 are laminated via a release layer 50 (which may function as a bonding layer) such as a resin at a temperature of 200°C to 400°C. Further, the semiconductor substrate 40 is embedded in a resin 60 to obtain a laminated substrate 70. Thereafter, the release layer 50 is irradiated with a laser, for example, ultraviolet light through the support glass G2, and thus the support glass G2 and the semiconductor substrate 40 embedded with the resin 60 are peeled off. The support glass G2 can be reused. The single conductor substrate 40 embedded in the resin 60 is wired with a copper wire or the like. The wiring with a copper wire or the like may be previously performed on the release layer. A substrate in which a semiconductor chip is embedded in the resin 60 may be used as the semiconductor substrate.

Since the support substrate has a high light transmittance, a visible light laser or an ultraviolet laser with large energy can be effectively used as a laser used for peeling.

Examples

Hereinafter, the present invention will be described with reference to Examples, but the present invention is not limited thereto.

[Experimental Example 1]

<Preparation and Evaluation of Amorphous Glass>

Glass raw materials were blended so as to obtain glass compositions shown in Tables 1 and 2 in terms of mol% based on oxides, and weighed such that a glass has a weight of 800 g. Next, the mixed glass raw materials were put into a platinum crucible, followed by being placed in an electric furnace at 1600°C, and were melted for about 5 hours, defoamed, and homogenized.

The obtained molten glass was poured into a mold, held at a temperature of a glass transition point for 1 hour, and then cooled to a room temperature at a rate of 0.5 °C/min to obtain a glass block. The results of evaluating the glass transition point, specific gravity, Young's modulus, fracture toughness value, and thermal expansion coefficient of the amorphous glass using a part of the obtained block are shown in Tables 1 and 2.

The blank in the table indicates that evaluation is not carried out. In the table, $R_2O$ represents the total content of $Li_2O$, $Na_2O$, and $K_2O$, and NWF represents the total content of $SiO_2$, $Al_2O_3$, $P_2O_5$, and $B_2O_3$.

G3 to G8, G11, G13, and G14 are examples of the amorphous glass according to the present invention, and G1, G2, G9, G10, G12, G15, and G16 are Comparative Examples.

(Specific Gravity $\rho$)

The specific gravity is measured by the Archimedes method.

(Glass Transition Point Tg)

The glass was ground using an agate mortar, about 80 mg of powder was placed in a platinum cell, the temperature was increased from room temperature to 1100°C at a temperature rising rate of 10/min, and a DSC curve was measured using a differential scanning calorimeter (DSC3300SA manufactured by Bruker Corporation) to determine a glass transition point Tg.

Alternatively, based on JIS R1618:2002, a thermal expansion curve was obtained at a temperature rising rate 10°C/min using a thermal dilatometer (TD5000SA manufactured by Bruker AXS Inc.), and a glass transition point Tg [unit: °C] and a thermal expansion coefficient [unit: 1/K] were obtained based on the obtained thermal expansion curve.

(Haze Value)

Using a haze meter (HZ-V3 manufactured by Suga Test Instruments Co., Ltd.), a haze value [unit: %] under a halogen lamp C light source was measured.

(Young's Modulus E)

The Young's modulus was measured by an ultrasonic pulse method (JIS R1602).

(Fracture Toughness Value Kc)

The fracture toughness value was measured by the IF method in accordance with JIS R1607:2015.

Table 1 (mol%)

| | G1 | G2 | G3 | G4 | G5 | G6 | G7 | G8 |
|---|---|---|---|---|---|---|---|---|
| $SiO_2$ | 50.0 | 51.2 | 55.0 | 59.5 | 52.5 | 50.0 | 57.0 | 54.5 |
| $Al_2O_3$ | 5.0 | 5.0 | 5.4 | 5.8 | 7.9 | 10.4 | 8.3 | 10.8 |
| $P_2O_5$ | 2.3 | 2.3 | 2.3 | 2.3 | 2.3 | 2.3 | 2.3 | 2.3 |
| $B_2O_3$ | 0.0 | 0.0 | 0.0 | 0.0 | 0.0 | 0.0 | 0.0 | 0.0 |
| $Li_2O$ | 34.1 | 34.1 | 30.0 | 25.0 | 30.0 | 30.0 | 25.0 | 25.0 |
| $Na_2O$ | 1.8 | 1.8 | 1.8 | 1.8 | 1.8 | 1.8 | 1.8 | 1.8 |
| $K_2O$ | 1.2 | 0.0 | 0.0 | 0.0 | 0.0 | 0.0 | 0.0 | 0.0 |
| $ZrO_2$ | 4.5 | 4.5 | 4.5 | 4.5 | 4.5 | 4.5 | 4.5 | 4.5 |
| $SnO_2$ | 0.0 | 0.0 | 0.0 | 0.0 | 0.0 | 0.0 | 0.0 | 0.0 |
| $Y_2O_3$ | 1.0 | 1.0 | 1.0 | 1.0 | 1.0 | 1.0 | 1.0 | 1.0 |
| $R_2O$ | 37.1 | 35.9 | 31.8 | 26.8 | 31.8 | 31.8 | 26.8 | 26.8 |
| NWF | 57 | 59 | 63 | 68 | 63 | 63 | 68 | 68 |
| $R_2O / (SiO_2 + Al_2O_3)$ | 0.67 | 0.64 | 0.53 | 0.41 | 0.53 | 0.53 | 0.41 | 0.41 |

(continued)

| | | G1 | G2 | G3 | G4 | G5 | G6 | G7 | G8 |
|---|---|---|---|---|---|---|---|---|---|
| R$_2$O / NWF | | 0.65 | 0.61 | 0.51 | 0.40 | 0.51 | 0.51 | 0.40 | 0.40 |
| (Al$_2$O$_3$ / Li$_2$O) / NWF | | 0.0026 | 0.0025 | 0.0029 | 0.0034 | 0.0042 | 0.0055 | 0.0049 | 0.0064 |
| Properties | $\rho$ (g/cm$^3$) | 2.60 | | 2.60 | 2.58 | 2.61 | 2.60 | 2.59 | 2.59 |
| | Tg | 494 | 494 | 504 | 537 | 514 | 535 | 542 | 562 |
| | Haze (%) | 0.02 | 0.02 | 0.05 | 0.03 | 0.11 | 0.12 | 0.12 | 0.1 |
| | E (GPa) | 92 | | 95 | 93 | 96 | 95 | 93 | 93 |
| | Kc (MPa·m$^{1/2}$) | | | 0.85 | 1.01 | 0.87 | 0.91 | 1.00 | 1.00 |
| | CTE (10$^{-7}$ °C$^{-1}$) | 124 | 117 | | | | | | |

Table 2 (mol%)

| | | G9 | G10 | G11 | G12 | G13 | G14 | G15 | G16 |
|---|---|---|---|---|---|---|---|---|---|
| SiO$_2$ | | 51.4 | 50.3 | 58.2 | 56.9 | 57.5 | 56.2 | 53.6 | 53.6 |
| Al$_2$O$_3$ | | 13.2 | 12.9 | 5.7 | 5.6 | 5.6 | 5.5 | 5.2 | 5.2 |
| P$_2$O$_5$ | | 2.3 | 2.3 | 2.3 | 2.3 | 2.3 | 2.3 | 2.3 | 2.3 |
| B$_2$O$_3$ | | 0.0 | 0.0 | 0.0 | 0.0 | 3.0 | 5.0 | 5.0 | 8.0 |
| Li$_2$O | | 25.0 | 24.2 | 24.4 | 23.9 | 24.2 | 23.6 | 22.5 | 22.5 |
| Na$_2$O | | 1.8 | 1.8 | 1.8 | 1.8 | 1.8 | 1.8 | 1.8 | 1.8 |
| K$_2$O | | 0.0 | 0.0 | 0.0 | 0.0 | 0.0 | 0.0 | 0.0 | 0.0 |
| ZrO$_2$ | | 4.5 | 4.5 | 4.5 | 4.5 | 4.5 | 4.5 | 4.5 | 1.5 |
| SnO$_2$ | | 1.0 | 3.0 | 0.0 | 0.0 | 0.0 | 0.0 | 0.0 | 0.0 |
| Y$_2$O$_3$ | | 1.0 | 1.0 | 3.0 | 5.0 | 1.0 | 1.0 | 5.0 | 5.0 |
| R$_2$O | | 26.8 | 26.0 | 26.2 | 25.7 | 26.0 | 25.4 | 24.3 | 24.3 |
| NWF | | 67 | 65 | 66 | 65 | 68 | 69 | 66 | 69 |
| R$_2$O / (SiO$_2$ + Al$_2$O$_3$) | | 0.42 | 0.41 | 0.41 | 0.41 | 0.41 | 0.41 | 0.41 | 0.41 |
| R$_2$O / NWF | | 0.40 | 0.40 | 0.40 | 0.40 | 0.38 | 0.37 | 0.37 | 0.35 |
| (Al$_2$O$_3$ / Li$_2$O) / NWF | | 0.0079 | 0.0081 | 0.0035 | 0.0036 | 0.0034 | 0.0034 | 0.0035 | 0.0034 |
| Properties | $\rho$ (g/cm$^3$) | 2.63 | 2.71 | 2.68 | 2.80 | 2.56 | 2.56 | 2.77 | 2.70 |
| | Tg | 585 | 608 | 548 | 572 | 516 | 503 | 538 | 516 |
| | Haze (%) | 0.03 | 0.10 | 0.02 | 0.03 | 0.12 | 0.05 | 0.06 | 0.05 |
| | E (GPa) | 95 | 99 | 95 | 99 | 94 | 95 | 97 | 94 |
| | Kc (MPa·m$^{1/2}$) | 1.00 | 1.00 | 0.93 | 0.91 | 0.90 | 0.88 | 0.92 | 0.88 |

<Crystallization Treatment and Evaluation of Glass Ceramics>

The obtained glass block was processed into a size of 50 mm × 50 mm × 1.5 mm, and then heat-treated under the conditions described in Tables 3 and 4 to obtain glass ceramics. In the columns of the crystallization conditions in the tables, the upper row is nucleation treatment conditions and the lower row is crystal growth treatment conditions. For example, when the upper row describes 550°C for 2 hours and the lower row describes 730°C for 2 hours, it means that the glass is held at 550°C for 2 hours and then held at 730°C for 2 hours.

In the crystallization treatment, an effect of a release agent was confirmed. When a glass of G13 was heat-treated without using the release agent on a setter plate of an alumina plate, the glass was stuck to the setter plate. When boron nitride was used as the release agent, the glass and the setter plate were not stuck to each other, and glass ceramic was obtained. When alumina cloth, alumina sheet, alumina particles, glass cloth, or talc was used as the release agent, the glass and the setter plate were not stuck to each other in each case, and glass ceramics were obtained.

The glass of G13 was heat-treated by using an alumina sheet as a release agent, and using a SiC plate, an alumina plate, a mullite cordierite plate, or a mullite plate as a setter plate, and as a result, glass ceramics were obtained in each case.

Examples 4, 5, 7, 9, 12 to 14 are Working Examples, and Examples 1 to 3, 6, 8, 10, and 11 are Comparative Examples.

The obtained glass ceramics were processed and mirror-polished to obtain a glass ceramic sheet having a thickness t of 0.7 mm. In addition, a rod-shaped sample for measuring the thermal expansion coefficient was prepared. A part of the remaining glass ceramics was pulverized and used for the analysis of precipitated crystals. The evaluation results of the glass ceramics are shown in Tables 3 and 4. The blank indicates that evaluation is not carried out.

(X-ray Diffraction: Precipitated Crystals)

Powder X-ray diffraction was measured under the following conditions to identify precipitated crystals.
Measurement device: Smart Lab manufactured by Rigaku Corporation
X-ray used: CuKa ray
Measurement range: $2\theta = 10°$ to $80°$
Speed: 1°/min
Step: 0.01°

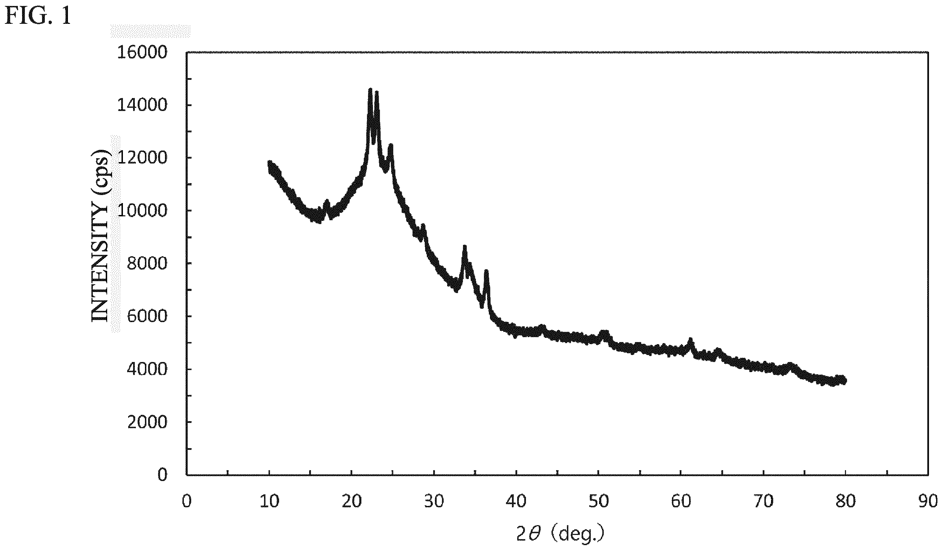

The detected main crystals are shown in the columns of crystals in Tables 3 and 4. Since it is difficult to determine $Li_3PO_4$ and $Li_4SiO_4$ by powder X-ray diffraction, both $Li_3PO_4$ and $Li_4SiO_4$ are shown together. FIG. 1 shows the results of measuring the glass ceramic of Example 4 by X-ray diffraction.

(Haze Value)

Using a haze meter (HZ-V3 manufactured by Suga Test Instruments Co., Ltd.), a haze value [unit: %] under a halogen lamp C light source was measured.

(CIL)

A sheet-shaped glass having a thickness of 0.7 mm in which both surfaces are mirror-polished was prepared. With a Vickers hardness tester, after a Vickers indenter (a tip angle was 136°) was pressed for 15 seconds, the Vickers indenter was removed, and after 15 seconds, the vicinity of an indentation was observed. In the observation, it was investigated how many cracks are generated from a corner of the indentation. The measurement was performed on 10 pieces of glass for each indentation load of the Vickers indenter of 10 gf, 25 gf, 50 gf, 100 gf, 200 gf, 300 gf, and 500 gf. An average value of the number of generated cracks was calculated for each load. A relationship between the load and the number of cracks was regressed using a sigmoid function. From the result of the regression calculation, the load at which the number of cracks was two was defined as the indentation load value (gf). An atmosphere condition of the measurement is that an air temperature is 25°C and a dew point is -40°C.

(ST Limit)

As a test glass sheet, a glass sheet having a 15 mm square and a thickness of 0.7 mm and having a mirror-finished surface was subjected to a chemical strengthening treatment under various conditions to prepare a plurality of test glass sheets having different ST values.

Using a Vickers tester, a diamond indenter with a tip angle of 90° was driven into a central portion of the test glass sheet to fracture the glass sheet, and the number of broken pieces was defined as the fragmentation number. In a case where the glass sheet was not cracked after a test is started with a driving load of the diamond indenter of 1 kgf, the driving load was increased by 1 kgf each time, the test was repeated until the glass sheet was cracked, and the fragmentation number when the glass sheet was cracked for the first time was counted.

The fragmentation number was plotted with respect to an ST value of the test glass sheet, and an ST value at which the fragmentation number was 10 was read and regarded as the ST limit.

Table 3

| | Ex. 1 | Ex. 2 | Ex. 3 | Ex. 4 | Ex. 5 | Ex. 6 | Ex. 7 | Ex. 8 | Ex. 9 | Ex. 10 |
|---|---|---|---|---|---|---|---|---|---|---|
| Glass | G1 | G2 | G3 | G4 | G5 | G5 | G6 | G6 | G7 | G8 |
| Heat Treatment Conditions | 550°C 2h 730°C 2h | 550°C 2h 710°C 2h | 620°C 2h 700°C 2h | 640°C 2h 740°C 2h | 630°C 2h 740°C 2h | 630°C 2h 800°C 2h | 640°C 2h 720°C 2h | 640°C 2h 820°C 2h | 640°C 2h 760°C 2h | 670°C 2h 700°C 2h |
| Crystal | $Li_2SiO_3$ | $Li_2SiO_3$ | $Li_2SiO_3$ | $Li_3PO_4$ $Li_4SiO_4$ | $Li_3PO_4$ $Li_4SiO_4$ | $Li_5AlSi_2O_8$ | $Li_3PO_4$ $Li_4SiO_4$ | $LiAlSiO_4$ | $Li_3PO_4$ $Li_4SiO_4$ | $LiAlSiO_4$ |
| $\rho$ (g/cm$^3$) | 2.65 | | 2.62 | 2.59 | 2.62 | 2.63 | 2.65 | 2.65 | 2.60 | 2.63 |
| Haze (%) | 0.08 | 0.08 | 0.21 | 0.02 | 0.02 | 0.1 | 0.05 | 0.15 | 0.05 | 0.12 |
| E (GPa) | 104 | | 99 | 96 | 99 | 99 | 103 | 102 | 97 | 98 |
| Kc (MPa·m$^{1/2}$) | 0.80 | | 0.81 | 0.92 | | 0.83 | | 0.82 | 0.93 | 0.86 |
| CIL (gf) | 25 | | 76 | 264 | | 85 | | | 242 | 209 |
| ST Limit (MPa·μm) | 22000 | | 22000 | 22000 | 23000 | 22000 | 22000 | 20000 | | 22000 |

Table 4

| | Example 11 | Example 12 | Example 13 | Example 14 |
|---|---|---|---|---|
| Glass | G9 | G11 | G13 | G14 |
| Heat Treatment Conditions | 640°C 2h 720°C 2h | 720°C 2h 780°C 0.5h | 640°C 2h 740°C 2h | 610°C 2h 720°C 2h |
| Crystal | LAS type | $Li_3PO_4$ $Li_4SiO_4$ | $Li_3PO_4$ $Li_4SiO_4$ | $Li_3PO_4$ $Li_4SiO_4$ |
| $\rho$ (g/cm$^3$) | 2.68 | 2.69 | 2.56 | 2.57 |
| Haze (%) | 0.66 | 0.03 | 0.07 | 0.09 |
| E (GPa) | 105 | 99 | 95 | 95 |
| Kc (MPa·m$^{1/2}$) | 0.86 | 0.84 | 0.88 | 0.87 |
| CIL (gf) | | | | |
| ST Limit (MPa·$\mu$m) | | 22000 | 24000 | 27000 |

In Tables 3 and 4, Examples 5 and 6 differ in the heat treatment conditions of G5, and Examples 7 and 8 differ in the heat treatment conditions of G6. From the comparison between Example 5 and Example 6 and the comparison between Example 7 and Example 8, it can be seen that, even if the glass ceramics of the present invention have the same composition, precipitated crystals can be changed by changing the heat treatment temperature, and the glass ceramics show different hazes. It is shown that the glass ceramics of the present invention have the haze reduced by precipitating $Li_3PO_4$ or $Li_4SiO_4$ and have excellent transparency.

<Chemical Strengthening Treatment and Evaluation of Strengthened Glass>

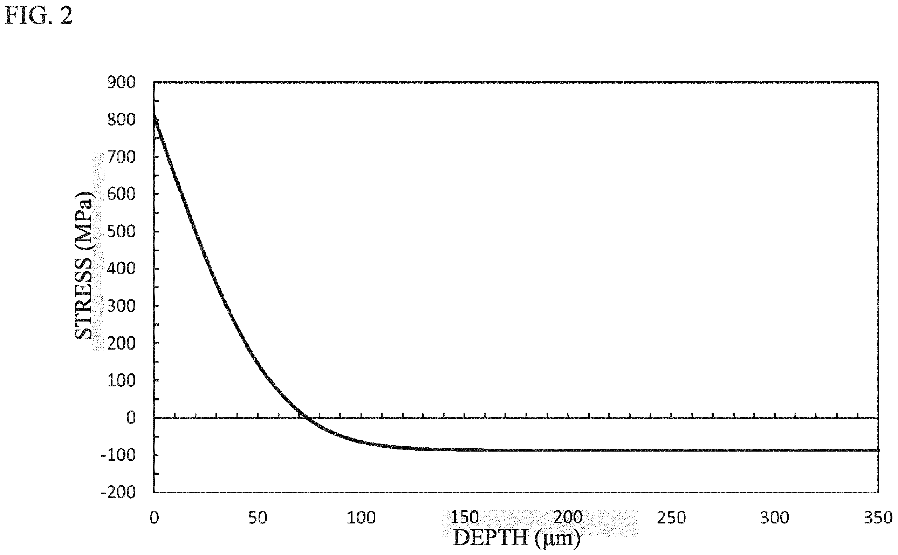

The glass ceramics of Examples 4 and 14 were chemically strengthened by the following method to obtain Examples 15 and 16, respectively. Examples 15 and 16 are Working Examples. A molten salt containing 0.3% by mass of lithium nitrate and 99.7% by mass of sodium nitrate was used as a strengthening salt, and the glass ceramics were held at 450°C for 30 minutes for ion exchange treatment to obtain a chemically strengthened glass. A stress profile of the obtained chemically strengthened glass was measured using a scattered light photoelastic stress meter SLP-2000 manufactured by Orihara Industrial Co., Ltd. The results are shown in Table 5. In Table 5, the glass ceramic of a glass G4 is indicated as GC4, and the glass ceramic of a glass G14 is indicated as GC14. FIG. 2 shows a stress profile of a chemically strengthened glass S1 obtained by chemically strengthening the glass ceramics of Example 4.

Table 5

| | | Example 15 | Example 16 |
|---|---|---|---|
| Glass Ceramics | | GC4 | GC14 |
| Chemical Strengthening Conditions | Strengthening Salt | 0.3% by mass of Li 99.7% by mass of Na | 0.3% by mass of Li 99.7% by mass of Na |
| | Temperature | 450°C | 450°C |
| | Holding Time | 0.5h | 0.5h |
| Crystal | | $Li_3PO_4$ $Li_4SiO_4$ | $Li_3PO_4$ $Li_4SiO_4$ |
| CS$_0$ (MPa) | | 809 | 488 |
| DOL ($\mu$m) | | 74 | 144 |

As shown in Table 5, the chemically strengthened glass of the present invention is excellent in transparency and strength.

[Experimental Example 2]

<Preparation and Evaluation of Amorphous Glass>

In the same manner as in Experimental Example 1, an amorphous glass having a glass composition shown in Table 6 in terms of mol% based on oxides was prepared, and the properties thereof were evaluated. The fracture toughness value K1c was evaluated by the following method. The results are shown in Table 6.

(Fracture Toughness Value K1c)

The fracture toughness value K1c (unit: $MPa \cdot m^{1/2}$) was measured by the DCDC method. With reference to the method described in M.Y He, M.R. Turner and A.G. Evans, Acta Metall. Mater. 43 (1995) 3453., by using a sample having a shape shown in FIG. 4 and a SHIMADZU autograph AGS-X5KN, a K1-v curve showing a relationship between a stress intensity factor K1 (unit: $MPa \cdot m^{1/2}$) and a crack growth rate v (unit: m/s) as shown in FIG. 5 was measured by the DCDC method, the obtained data of Region III was regressed by a linear expression and extrapolated, and the stress intensity factor K1 of 0.1 m/s was defined as the fracture toughness value K1c.

Table 6 (mol%)

| | G17 | G18 | G19 | G20 | G21 | G22 | G23 | G24 | G25 | G26 | G27 | G28 |
|---|---|---|---|---|---|---|---|---|---|---|---|---|
| $SiO_2$ | 62 | 66.75 | 61 | 61 | 61 | 61 | 61 | 57 | 63 | 63 | 64 | 63 |
| $Al_2O_3$ | 3 | 1.5 | 3 | 5 | 7 | 5 | 5 | 7 | 5 | 5 | 5 | 5 |
| $Li_2O$ | 25 | 25 | 25 | 23 | 21 | 21 | 19 | 21 | 19 | 18 | 17 | 18 |
| $Na_2O$ | 2 | 2 | 2 | 2 | 2 | 2 | 2 | 2 | 2 | 2 | 2 | 1 |
| $K_2O$ | 0 | 2 | 0 | 0 | 0 | 0 | 0 | 0 | 0 | 0 | 0 | 1 |
| CaO | 0 | 0 | 0 | 0 | 0 | 0 | 0 | 0 | 0 | 0 | 0 | 0 |
| $P_2O_5$ | 2 | 1.75 | 2 | 2 | 2 | 2 | 2 | 2 | 2 | 2 | 2 | 2 |
| $B_2O_3$ | 0 | 0 | 0 | 0 | 0 | 0 | 0 | 0 | 0 | 0 | 0 | 0 |
| MgO | 5 | 0 | 5 | 5 | 5 | 5 | 5 | 5 | 5 | 5 | 5 | 5 |
| $ZrO_2$ | 1 | 1 | 1 | 1 | 1 | 3 | 5 | 5 | 3 | 4 | 4 | 4 |
| $Y_2O_3$ | 0 | 0 | 1 | 1 | 1 | 1 | 1 | 1 | 1 | 1 | 1 | 1 |
| Total | 100 | 100 | 100 | 100 | 100 | 100 | 100 | 100 | 100.000 | 100.000 | 100.000 | 100.000 |
| $\rho$ (g/cm³) | | | 2.49 | 2.49 | 2.49 | 2.56 | 2.63 | 2.63 | | | 2.57 | 2.57 |
| Tg (°C) | 449 | 468 | 471 | 480 | 525 | 513 | 552 | | | | | |
| Haze (%) | 0.03 | 0.02 | 0.02 | 0.02 | 0.03 | 0.02 | 0.02 | 0.02 | 0.02 | 0.02 | 0.02 | 0.02 |
| E (GPa) | 88 | | 92 | 92 | 92 | 90 | 95 | 95 | | | 93 | 95 |
| Kc ($MPa \cdot m^{1/2}$) | | | 1 | 1 | 1 | 0.98 | 0.99 | 0.91 | | | | |
| K1c ($MPa \cdot m^{1/2}$) | | | | | | 0.85 | | | | | | |
| CTE ($10^{-7}$ °C⁻¹) | 102 | | 105 | | 92 | 90 | 84 | | | | | |

<Crystallization Treatment and Evaluation of Glass Ceramics>

Glass ceramics were obtained in the same manner as in Experimental Example 1, and the properties thereof were evaluated. X-ray diffraction was evaluated according to the following conditions.

(X-ray Diffraction: Precipitated Crystals)

Powder X-ray diffraction was measured under the following conditions to identify precipitated crystals.
Measurement device: Smart Lab manufactured by Rigaku Corporation
X-ray used: CuKa ray
Measurement range: 2θ = 10° to 80°
Speed: 10°/min
Step: 0.02°

The results are shown in Table 7. In Table 7, Examples 18 to 27 are Working Examples, and Example 17 is a Comparative Example.

Table 7

| | Example 17 | Example 18 | Example 19 | Example 20 | Example 21 | Example 22 | Example 23 | Example 24 | Example 25 | Example 26 | Example 27 |
|---|---|---|---|---|---|---|---|---|---|---|---|
| Glass | G17 | G19 | G20 | G21 | G22 | G23 | G24 | G25 | G26 | G27 | G28 |
| Heat Treatment Conditions | 550°C 2h 650°C 2h | 500°C 2h 630°C 2h | 550°C 2h 630°C 2h | 550°C 2h 650°C 2h | 550°C 2h 750°C 2h | 650°C 2h 780°C 2h | 550°C 2h 710°C 2h | 550°C 2h 670°C 2h | 550°C 2h 760°C 2h | 550°C 2h 690°C 2h | 550°C 2h 750°C 2h |
| Crystal | $Li_2SiO_3$ | $Li_3PO_4$ | $Li_3PO_4$ | $Li_3PO_4$ | $Li_3PO_4$ | $Li_3PO_4$ | $Li_3PO_4$ | | | | |
| $\rho$ (g/cm$^3$) | | 2.5 | 2.49 | 2.49 | 2.56 | 2.62 | 2.63 | | | | |
| Haze (%) | | 0.09 | 0.02 | 0.03 | 0.03 | 0.03 | 0.02 | 0.04 | 0.03 | 0.09 | 0.03 |
| E (GPa) | | 93 | 94 | 95 | 95 | 98 | 97 | | | | |
| Kc (MPa·m$^{1/2}$) | | 0.81 | 0.79 | 0.9 | 0.95 | 0.91 | 0.86 | | | | |
| CIL(gf) | | | | | | | | | | | |
| ST Limit (MPa·$\mu$m) | | | | | 23000 | | | | | | |
| K1c (MPa·m$^{1/2}$) | | | | | 0.88 | | | | | | |

As shown in Table 7, the glass of the present invention had a small haze value and excellent transparency.

The chemical resistance of Example 2 in Table 3 and Example 21 in Table 7 was evaluated. The glass was immersed in HCl of pH 1 at room temperature for 1 minute, and then immersed in NaOH of pH 12.5 at 65°C for 6 minutes. Then, the haze and transmittance were measured, and in Example 2, the haze increased to 0.73%, and the transmittance at 550 nm decreased by 4.8%. On the other hand, in Example 21, it was found that the haze remained almost unchanged at 0.03%, and the transmittance at 550 nm decreased only by 0.7%. It can be seen that Example 21 in which a $Li_3PO_4$ crystal is precipitated is superior in chemical resistance to Example 2 in which a $Li_2SiO_3$ crystal is precipitated.

[Experimental Example 3]

<Preparation and Evaluation of Amorphous Glass>

In the same manner as in Example 1, an amorphous glass having a glass composition shown in Table 8 in terms of mol% based on oxides was prepared, and the properties thereof were evaluated. However, $SO_3$, Cl, and $SnO_2$ added as refining agents are expressed in mass%. The results are shown in Table 8.

Table 8

| mol% | G29 | G30 | G31 | G32 | G33 | G34 |
|---|---|---|---|---|---|---|
| $SiO_2$ | 61 | 61 | 61 | 61 | 61 | 61 |
| $Al_2O_3$ | 5 | 5 | 5 | 5 | 5 | 5 |
| $Li_2O$ | 21 | 21 | 21 | 21 | 21 | 21 |
| $Na_2O$ | 2 | 2 | 2 | 2 | 2 | 2 |
| $K_2O$ | 0 | 0 | 0 | 0 | 0 | 0 |
| CaO | 0 | 0 | 0 | 0 | 0 | 0 |
| $P_2O_5$ | 2 | 2 | 2 | 2 | 2 | 2 |
| $B_2O_3$ | 0 | 0 | 0 | 0 | 0 | 0 |
| MgO | 5 | 5 | 5 | 5 | 5 | 5 |
| $ZrO_2$ | 3 | 3 | 3 | 3 | 3 | 3 |
| $Y_2O_3$ | 1 | 1 | 1 | 1 | 1 | 1 |
| $SO_3$ (wt%) | 0.3 | 0.3 | 0 | 0 | 0 | 0 |
| Cl (wt%) | 0 | 0 | 1 | 1 | 0.5 | 1 |
| $SnO_2$ (wt%) | 0.05 | 0.1 | 0.05 | 0.1 | 0 | 0 |
| $\rho$ (g/cm$^3$) | 2.56 | 2.56 | 2.56 | 2.56 | 2.56 | 2.56 |
| Tg (°C) | 513 | | | | | |
| Haze (%) | 0.02 | 0.02 | 0.02 | 0.02 | 0.02 | 0.02 |
| E (GPa) | 90 | 90 | 90 | 90 | 90 | 90 |
| Kc (MPa·m$^{1/2}$) | 0.95 | 0.95 | 0.95 | 0.95 | 0.95 | 0.95 |
| K1c (MPa·m$^{1/2}$) | 0.85 | 0.85 | 0.85 | 0.85 | 0.85 | 0.85 |

<Crystallization Treatment and Evaluation of Glass Ceramics>

Glass ceramics were obtained in the same manner as in Example 1, and the properties thereof were evaluated. The results are shown in Table 9. In Table 9, Examples 28 to 33 are all Working Examples.

Table 9

| | Example 28 | Example 29 | Example 30 | Example 31 | Example 32 | Example 33 |
|---|---|---|---|---|---|---|
| Glass | G29 | G30 | G31 | G32 | G33 | G34 |

(continued)

|  | Example 28 | Example 29 | Example 30 | Example 31 | Example 32 | Example 33 |
|---|---|---|---|---|---|---|
| Heat Treatment Conditions | 550°C 2h 750°C 2h | 550°C 2h 750°C 2h | 550°C 2h 750°C 2h | 550°C 2h 750°C 2h | 550°C 2h 750°C 2h | 550°C 2h 750°C 2h |
| Crystal | $Li_3PO_4$ | $Li_3PO_4$ | $Li_3PO_4$ | $Li_3PO_4$ | $Li_3PO_4$ | $Li_3PO_4$ |
| $\rho$ (g/cm$^3$) |  |  |  |  |  |  |
| Haze (%) | 0.02 | 0.02 | 0.02 | 0.02 | 0.02 | 0.02 |
| E (GPa) | 95 | 95 | 95 | 95 | 95 | 95 |
| Kc (MPa·m$^{1/2}$) | 0.95 | 0.95 | 0.95 | 0.95 | 0.95 | 0.95 |
| CIL (gf) |  |  |  |  |  |  |
| K1c (MPa·m$^{1/2}$) | 0.88 | 0.88 | 0.88 | 0.88 | 0.88 | 0.88 |

As shown in Table 9, it can be seen that the glass of the present invention does not affect the optical properties and the mechanical properties even when the refining agents $SO_3$, Cl, and $SnO_2$ are added alone or in combination.

Table 10 shows polishing rates of the amorphous glass and the glass of the present invention. Example 34 is a Comparative Example, and Examples 4 and 21 are Working Examples.

Table 10

| mol% | Example 34 | Example 4 | Example 21 |
|---|---|---|---|
| Glass | G35 | G4 | G22 |
| $SiO_2$ | 66.2 | 59.5 | 61.0 |
| $Al_2O_3$ | 11.2 | 5.8 | 5.0 |
| $Li_2O$ | 10.4 | 25.0 | 21.0 |
| $Na_2O$ | 5.6 | 1.8 | 2.0 |
| $K_2O$ | 1.5 | 0.0 | 0.0 |
| CaO | 0.2 | 0.0 | 0.0 |
| $P_2O_5$ | 0 | 2.3 | 2.0 |
| $B_2O_3$ | 0 | 0.0 | 0.0 |
| MgO | 3.1 | 0.0 | 5.0 |
| $ZrO_2$ | 1.3 | 4.5 | 3.0 |
| $Y_2O_3$ | 0.5 | 1.0 | 1.0 |
| Heat Treatment Conditions | - | 640°C 2h 740°C 2h | 550°C 2h 750°C 2h |
| Crystal | - | $Li_3PO_4$ $Li_4SiO_4$ | $Li_3PO_4$ |
| $\rho$ (g/cm$^3$) | 2.49 | 2.59 | 2.56 |
| Haze (%) | 0.02 | 0.02 | 0.03 |
| E (GPa) | 86 | 96 | 95 |
| Kc (MPa·m$^{1/2}$) |  | 0.92 | 0.95 |
| Polishing Rate ($\mu$m/min) | 0.45 | 0.5 | 0.71 |

As shown in Table 10, it can be seen that the glass of the present invention has a larger polishing rate after crystallization than that of a general amorphous glass and is excellent in processability.

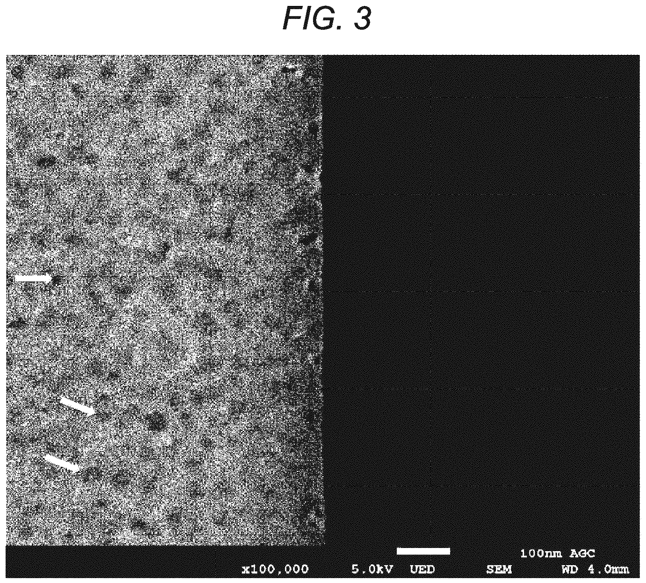

FIG. 3 is a cross-sectional FE-SEM image of Example 21. In FIG. 3, an example of a precipitated crystal is indicated by a white arrow. As a result of measuring a size of the precipitated crystal under the following conditions, it was found that the size was 20 nm to 50 nm. Since the crystal size is small, the glass is less likely to be affected by scattering and is excellent in optical properties.

Apparatus: JSM-7800F Prime manufactured by JEOL Ltd.
Measurement Conditions:
Vacc: 5 kV, Coating: W, UED Image

In the Rietveld analysis, when the precipitated crystal was $Li_{6.5}(Si, P)Os$, the crystallinity was 18.2%, and a crystallite diameter was 15 nm.

Although the present invention has been described in detail with reference to specific aspects, it is apparent to those skilled in the art that various changes and modifications can be made without departing from the spirit and the scope of the present invention. The present application is based on a Japanese patent application (No. 2020-140347) filed on August 21, 2020 and a Japanese patent application (No. 2021-090475) filed on May 28, 2021, the entire contents of which are incorporated herein by reference. In addition, all references cited here are entirely incorporated.

**Claims**

1. A chemically strengthened glass having a haze value in terms of a thickness of 0.7 mm of 0.5% or less,

   having a surface compressive stress value of 400 MPa or more,
   having a depth of a compressive stress layer of 70 $\mu$m or more,
   having an ST limit determined by the following test method of 18000 MPa·$\mu$m to 30000 MPa·$\mu$m, and
   being a glass ceramic comprising at least one of a $Li_3PO_4$ crystal and a $Li_4SiO_4$ crystal, or comprising a solid solution crystal of $Li_3PO_4$ or $Li_4SiO_4$ or a solid solution of both $Li_3PO_4$ and $Li_4SiO_4$,
   TEST METHOD:

   as a test glass sheet, a glass sheet having a 15 mm square and a thickness of 0.7 mm and having a mirror-finished surface is subjected to a chemical strengthening treatment under various conditions to prepare a plurality of test glass sheets having different ST values which are tensile stress integral values;
   using a Vickers tester, a diamond indenter with a tip angle of 90° is driven into a central portion of the test glass sheet to fracture the glass sheet, and the number of broken pieces is defined as a fragmentation number, in a case where the glass sheet is not cracked after a test is started with a driving load of the diamond indenter of 1 kgf, the driving load is increased by 1 kgf each time, the test is repeated until the glass sheet is cracked, and the fragmentation number when the glass sheet is cracked for the first time is counted; and
   the fragmentation number is plotted with respect to an ST value of the test glass sheet, and an ST value at which the fragmentation number is 10 is read and is regarded as the ST limit.

2. The chemically strengthened glass according to claim 1, wherein a base composition of the chemically strengthened glass comprises, in terms of mol% based on oxides:

   40% to 70% of $SiO_2$;
   10% to 35% of $Li_2O$;
   1% to 15% of $Al_2O_3$;
   0.5% to 5% of $P_2O_5$;
   0.5% to 5% of $ZrO_2$;
   0% to 10% of $B_2O_3$;
   0% to 3% of $Na_2O$;
   0% to 1% of $K_2O$; and
   0% to 4% of $SnO_2$, and
   has a total content of $SiO_2$, $Al_2O_3$, $P_2O_5$, and $B_2O_3$ of 60% to 80%.

3. The chemically strengthened glass according to claim 2, wherein the content of AlzOs is 5% or more and the content of $ZrO_2$ is 2% or more.

4. The chemically strengthened glass according to claim 1, comprising:

> 50% to 70% of $SiO_2$;
> 15% to 30% of $Li_2O$;
> 1% to 10% of $Al_2O_3$;
> 0.5% to 5% of $P_2O_5$;
> 0.5% to 8% of $ZrO_2$;
> 0.1% to 10% of $MgO$;
> 0% to 5% of $Y_2O_3$;
> 0% to 10% of $B_2O_3$;
> 0% to 3% of $Na_2O$;
> 0% to 1% of $K_2O$; and
> 0% to 2% of $SnO_2$.

5. The chemically strengthened glass according to any one of claims 1 to 4, wherein an average thermal expansion coefficient at 50°C to 350°C is $80 \times 10^{-7}$/°C to $100 \times 10^{-7}$/°C.

6. A semiconductor support substrate comprising the chemically strengthened glass according to any one of claims 1 to 5.

7. A glass ceramic comprising at least one of a $Li_3PO_4$ crystal and a $Li_4SiO_4$ crystal, or comprising a solid solution crystal of $Li_3PO_4$ or $Li_4SiO_4$ or solid solution of both $Li_3PO_4$ and $Li_4SiO_4$,

> having a haze value in terms of a thickness of 0.7 mm of 0.5% or less, and
> having an ST limit determined by the following test method of 18000 MPa·μm or more,
> TEST METHOD:
>
> > as a test glass sheet, a glass sheet having a 15 mm square and a thickness of 0.7 mm and having a mirror-finished surface is subjected to a chemical strengthening treatment under various conditions to prepare a plurality of test glass sheets having different ST values which are tensile stress integral values;
> > using a Vickers tester, a diamond indenter with a tip angle of 90° is driven into a central portion of the test glass sheet to fracture the glass sheet, and the number of broken pieces is defined as a fragmentation number, in a case where the glass sheet is not cracked after a test is started with a driving load of the diamond indenter of 1 kgf, the driving load is increased by 1 kgf each time, the test is repeated until the glass sheet is cracked, and the fragmentation number when the glass sheet is cracked for the first time is counted; and
> > the fragmentation number is plotted with respect to an ST value of the test glass sheet, and an ST value at which the fragmentation number is 10 is read and is regarded as the ST limit.

8. A glass ceramic comprising, in terms of mol% based on oxides:

> 40% to 70% of $SiO_2$;
> 10% to 35% of $Li_2O$;
> 1% to 15% of $Al_2O_3$;
> 0.5% to 5% of $P_2O_5$;
> 0.5% to 5% of $ZrO_2$;
> 0% to 10% of $B_2O_3$;
> 0% to 3% of $Na_2O$;
> 0% to 1% of $K_2O$; and
> 0% to 4% of $SnO_2$,
> having a total content of $SiO_2$, $Al_2O_3$, $P_2O_5$, and $B_2O_3$ of 60% to 80%, and
> having a ratio of a total content of $Li_2O$, $Na_2O$ and $K_2O$ to the total content of $SiO_2$, $Al_2O_3$, $PzOs$ and $B_2O_3$ of 0.20 to 0.60 and comprising $Li_3PO_4$ or $Li_4SiO_4$ as a main crystal.

9. The glass ceramic according to claim 8, wherein the content of $Al_2O_3$ is 5% or more and the content of $ZrO_2$ is 2% or more.

10. The glass ceramic according to claim 7, comprising:

50% to 70% of $SiO_2$;
15% to 30% of $Li_2O$;
1% to 10% of $Al_2O_3$;
0.5% to 5% of $P_2O_5$;
0.5% to 8% of $ZrO_2$;
0.1% to 10% of $MgO$;
0% to 5% of $Y_2O_3$;
0% to 10% of $B_2O_3$;
0% to 3% of $Na_2O$;
0% to 1% of $K_2O$; and
0% to 2% of $SnO_2$.

11. A method for producing a glass ceramic, the method comprising performing a heat treatment to hold a glass at a temperature of 450°C or higher and 800°C or lower,

the glass comprising, in terms of mol% based on oxides:

40% to 70% of $SiO_2$;
10% to 35% of $Li_2O$;
1% to 15% of $Al_2O_3$,
0.5% to 5% of $P_2O_5$;
0.5% to 5% of $ZrO_2$;
0% to 10% of $B_2O_3$;
0% to 3% of $Na_2O$;
0% to 1% of $K_2O$; and
0% to 4% of $SnO_2$,
having a total content of $SiO_2$, $Al_2O_3$, $P_2O_5$, and $B_2O_3$ of 60% to 80%, and
having a ratio of a total content of $Li_2O$, $Na_2O$ and $K_2O$ to the total content of $SiO_2$, $AlzOs$, $P_2O_5$ and $B_2O_3$ of 0.20 to 0.60.

12. A method for producing a chemically strengthened glass article, the method comprising:
chemically strengthening an article comprising the glass ceramic according to any one of claims 7 to 10.

13. The glass ceramic according to any one of claims 7 to 10, wherein an average thermal expansion coefficient at 50°C to 350°C is $80 \times 10^{-7}$/°C to $100 \times 10^{-7}$/°C.

14. A semiconductor support substrate comprising the glass ceramic according to any one of claims 7 to 10.

FIG. 1

FIG. 2

## FIG. 3

## FIG. 4

Depth : d

Width : w

Crack Length

Length : L

Radius : L

## FIG. 5

K1-v CURVE

v=0.1 m/s

CRACK GROWTH RATE v m/s

Region II    Region III

Region I

K1c

STRESS INTENSITY FACTOR K1 MPa·m$^{1/2}$

## FIG. 6A

G1

20

10

## FIG. 6B

30

G1

20

10

## FIG. 7

70  60  40

50

G2

## INTERNATIONAL SEARCH REPORT

| International application No. |
| --- |
| PCT/JP2021/029569 |

### A. CLASSIFICATION OF SUBJECT MATTER
C03C 10/04(2006.01)i; C03B 32/02(2006.01)i; C03C 10/02(2006.01)i; C03C 21/00(2006.01)i
FI: C03C10/04; C03B32/02; C03C10/02; C03C21/00 101

According to International Patent Classification (IPC) or to both national classification and IPC

### B. FIELDS SEARCHED

Minimum documentation searched (classification system followed by classification symbols)
C03C10/04; C03B32/02; C03C10/02; C03C21/00

| Documentation searched other than minimum documentation to the extent that such documents are included in the fields searched | |
| --- | --- |
| Published examined utility model applications of Japan | 1922–1996 |
| Published unexamined utility model applications of Japan | 1971–2021 |
| Registered utility model specifications of Japan | 1996–2021 |
| Published registered utility model applications of Japan | 1994–2021 |

Electronic data base consulted during the international search (name of data base and, where practicable, search terms used)
INTERGLAD

### C. DOCUMENTS CONSIDERED TO BE RELEVANT

| Category* | Citation of document, with indication, where appropriate, of the relevant passages | Relevant to claim No. |
| --- | --- | --- |
| X<br>A | WO 2020/161949 A1 (AGC INC.) 13 August 2020 (2020-08-13) paragraphs [0001], [0009], [0083], [0139], tables 1, 3-4, 6-7, claims 1, 13 | 1-7, 12-14<br>8-11 |
| X<br>A | JP 2018-526317 A (IVOCLAR VIVADENT AG) 13 September 2018 (2018-09-13) paragraph [0029], example 24, table 1 | 8, 10<br>1-7, 9, 11-14 |
| X<br>A | JP 10-226532 A (YAMAMURA GLASS CO., LTD.) 25 August 1998 (1998-08-25) example 1, table 3-1, claim 1, paragraph [0005] | 7-11, 13<br>1-6, 12, 14 |

☐ Further documents are listed in the continuation of Box C.　　☒ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 10 September 2021 (10.09.2021) | 21 September 2021 (21.09.2021) |

| Name and mailing address of the ISA/ | Authorized officer |
| --- | --- |
| Japan Patent Office<br>3-4-3, Kasumigaseki, Chiyoda-ku,<br>Tokyo 100-8915, Japan | Telephone No. |

Form PCT/ISA/210 (second sheet) (January 2015)

INTERNATIONAL SEARCH REPORT

Information on patent family members

International application No.

PCT/JP2021/029569

| Patent Documents referred in the Report | Publication Date | Patent Family | Publication Date |
|---|---|---|---|
| WO 2020/161949 A1 | 13 Aug. 2020 | (Family: none) | |
| JP 2018-526317 A | 13 Sep. 2018 | US 2018/0244564 A1 paragraph [0028], example 24, table 1 EP 3135641 A1 CA 2995309 A1 KR 10-2018-0043335 A CN 108025949 A | |
| JP 10-226532 A | 25 Aug. 1998 | US 5691256 A example 1, table 3, claim 1, page 3, right column, line 6 EP 781731 A1 | |

Form PCT/ISA/210 (patent family annex) (January 2015)

**REFERENCES CITED IN THE DESCRIPTION**

**Patent documents cited in the description**

- WO 2019022035 A
- JP 2020140347 A
- JP 2021090475 A

**Non-patent literature cited in the description**

- **M.Y. HE ; M.R. TURNER ; A.G. EVANS.** *Acta Metall. Mater.,* 1995, vol. 43, 3453
- *Asahi Glass Research Report,* 2017, vol. 67
- **M.Y HE ; M.R. TURNER ; A.G. EVANS.** *Acta Metall. Mater.,* 1995, vol. 43, 3453